(19) Europäisches Patentamt
European Patent Office
Office européen des brevets

(11) EP 3 139 141 A2

(12) DEMANDE DE BREVET EUROPEEN

(43) Date de publication:
08.03.2017 Bulletin 2017/10

(51) Int Cl.:
G01J 5/08 (2006.01)         G01J 5/02 (2006.01)
G02B 5/20 (2006.01)         G01J 3/12 (2006.01)

(21) Numéro de dépôt: 16186678.5

(22) Date de dépôt: 31.08.2016

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME
Etats de validation désignés:
MA MD

(30) Priorité: 03.09.2015  FR 1501823
16.06.2016  FR 1600966

(71) Demandeur: Commissariat à l'énergie atomique
et aux énergies alternatives
75015 Paris (FR)

(72) Inventeurs:
• BADANO, Giacomo
38250 LANS EN VERCORS (FR)
• LESMANNE, Emeline
38600 FONTAINE (FR)

(74) Mandataire: Brevalex
95, rue d'Amsterdam
75378 Paris Cedex 8 (FR)

(54) COMPOSANT POUR LA DÉTECTION D'UN RAYONNEMENT ÉLECTROMAGNÉTIQUE DANS UNE GAMME DE LONGUEURS D'ONDE ET PROCÉDÉ DE FABRICATION D'UN TEL COMPOSANT

(57)   L'invention concerne un composant (1) destiné à la détection et/ou la mesure d'un rayonnement électromagnétique dans une première gamme de longueurs d'onde. Le composant (1) comporte un support (10) comportant au moins une première structure (111, 112) et une face de réception (121) pour recevoir le rayonnement électromagnétique ; un filtre optique (20) du type passe bande dans la première gamme de longueurs d'onde disposé sur la face de réception (121) du support (10). Le filtre optique (20) comporte une zone d'adaptation (220) recouvrant la face de réception (121) du support (10) et d'indice de réfraction inférieur à 2 ; une première couche métallique (230) recouvrant la zone d'adaptation (220) et comprenant des trous traversants (231) régulièrement répartis. Chacun des trous traversants (231) contient un matériau de remplissage (232).

FIG. 1A

EP 3 139 141 A2

## Description

## DOMAINE TECHNIQUE

L'invention concerne le domaine de la détection des rayonnements électromagnétiques dans la gamme des infrarouges et du visible et a plus précisément pour objet un composant destiné à la détection d'un rayonnement électromagnétique dans une première gamme de longueurs d'onde comprise dans la gamme des infrarouges et du visible et le procédé de fabrication d'un tel composant.

Dans certaines applications de l'invention, l'invention a également pour objet un composant destiné à permettre la détection de rayonnement électromagnétique dans au moins deux gammes de longueurs d'onde comprises dans la gamme des infrarouges et du visible.

## ÉTAT DE LA TECHNIQUE ANTÉRIEURE

Pour certaines applications d'imagerie ou de spectroscopie dans l'infrarouge et le visible, il est nécessaire de pouvoir détecter et/ou mesurer uniquement les rayonnements électromagnétiques dont les longueurs d'onde sont comprises dans une gamme de longueurs d'onde prédéfinie.

C'est pour répondre à ces besoins que les filtres optiques du type passe bande ont été développés. Ces filtres de type passe-bande peuvent en effet être associés avec des structures aptes à absorber un rayonnement électromagnétique. Ainsi, un tel filtre optique permet de transmettre à ces structures majoritairement la partie du rayonnement électromagnétique se trouvant dans une gamme de longueurs d'onde bien définie. C'est donc majoritairement cette partie du rayonnement électromagnétique qui sera détectée par ces structures.

Par filtre passe bande dans une gamme de longueurs d'onde, il doit être entendu ci-dessus et dans le reste de ce document qu'un tel filtre recevant un rayonnement électromagnétique dont une partie du spectre est comprise dans la gamme de longueurs d'onde transmet majoritairement ladite partie, le reste du spectre étant au moins partiellement réfléchi et/ou absorbé.

De tels filtres passe bande sont basés sur les surfaces sélectives en fréquence déjà utilisées pour les radiofréquences.

Les travaux de Kristensen et de ses collaborateurs publiés dans la revue scientifique Journal of Applied Physics volume 95 pages 4845 en 2004, illustrent une telle application des surfaces sélectives en fréquence pour former un filtre passe bande dans une gamme de longueurs d'onde comprise dans les infrarouges.

Il doit être entendu, ci-dessus, et dans le reste de ce document, par surface sélective en fréquence, une couche métallique optiquement opaque sauf en correspondance de trous traversants identiques, le dimensionnement des trous traversants de ladite surface sélective en fréquence étant adaptés pour que chacun des trous présente une section efficace de transmission maximale dans une gamme de longueurs d'onde donnée et sensiblement nulle en dehors. La transmission d'une telle surface sélective en fréquence dans la gamme de longueurs d'onde donnée résulte donc de la somme des transmissions de chacun des trous traversants. Ainsi si dans une configuration classique les trous traversants participant à la formation d'une surface sélective en fréquence sont répartis régulièrement sur la surface métallique, une telle surface sélective en fréquence peut également être formée à partir de trous traversants présentant une distribution aléatoire dans la couche métallique.

Un tel filtre optique, disposé sur un substrat de silicium pouvant intégrer une ou plusieurs structures semiconductrices, comporte :

- une première couche de silice recouvrant le substrat,
- une couche métallique en aluminium recouvrant la première couche de silice et comprenant des trous traversants répartis et dimensionnés pour former une surface sélective en fréquence,
- une deuxième couche de silice recouvrant la couche métallique.

Les trous traversants de la couche métallique sont également remplis de silice.

Ce type de filtre, de la même façon qu'une surface sélective en fréquence dans la gamme de fréquence des radiofréquences, permet de fournir un filtre passe bande dans une gamme de longueurs d'onde comprise dans la gamme des infrarouges. Ainsi, un tel filtre optique permet, en l'associant avec une à plusieurs structures absorbantes, de former un composant pour détecter et/ou mesurer un rayonnement dans une gamme de longueurs d'onde donnée.

Ce type de filtre décrit par Kristensen et ses collaborateurs présente néanmoins un certain nombre d'inconvénients. Avec un tel filtre optique la taille moyenne des motifs et donc leur période sont proches de la longueur d'onde de la lumière à filtrer. Or le premier ordre de diffraction apparait à une longueur d'onde égale à la période. Il résulte ainsi de cette période, et de la diffraction qu'une telle période occasionne, l'apparition d'un pic parasite et une excitation du guidage de photons dans la silice. Cela a pour conséquence un gabarit de transmission avec un tel filtre optique non optimal, le pic de transmission du filtre optique étant fortement asymétrique, et une réjection dégradée.

## EXPOSÉ DE L'INVENTION

La présente invention vise à remédier à plusieurs de ces inconvénients et a donc plus précisément pour objet la fourniture d'un composant destiné à la détection et/ou la mesure d'un rayonnement électromagnétique dans une première gamme de longueurs d'onde comprise dans la gamme des infrarouges et du visible dont le filtre optique peut être à même de présenter un taux de transmission optimisé par rapport au filtre optique d'un composant de l'art antérieur.

L'invention concerne à cet effet un composant destiné à la détection et/ou la mesure d'un rayonnement électromagnétique dans une première gamme de longueurs d'onde comprise dans la gamme des infrarouges et du visible, le composant comportant :

- un support comportant une face de réception pour recevoir le rayonnement électromagnétique et au moins une première structure apte à absorber un rayonnement électromagnétique,
- un filtre optique dont au moins une première portion associée à la première structure est du type filtre passe bande dans la première gamme de longueurs d'onde, le filtre optique étant disposé sur la face de réception du support de manière à filtrer le rayonnement électromagnétique transmis au support,

le filtre optique comportant:

- une zone d'adaptation recouvrant au moins en partie la face de réception du support, la zone d'adaptation présentant un indice de réfraction dans la première gamme de longueurs d'onde qui est inférieur à 2,
- une première couche métallique recouvrant la zone d'adaptation et comprenant des premiers trous traversants répartis et dimensionnés pour que la couche métallique forme une surface sélective en fréquence.

Chacun des premiers trous traversants contient un matériau de remplissage dont l'indice de réfraction dans la première gamme de longueurs d'onde est supérieur à 2.

Un matériau de remplissage de chacun des premiers et deuxièmes trous traversants présentant un fort indice de réfraction par rapport à celui de la zone d'adaptation permet de fournir un filtre optique avec une réjection améliorée. Il en résulte pour un tel filtre optique un pic de transmission plus étroit et avec une symétrie améliorée vis-à-vis d'un filtre optique de l'art antérieur, tel que celui décrit par Kristensen et ses collaborateurs. La distance entre les trous traversants peut donc être inférieure aux longueurs d'onde de la première gamme de longueurs d'onde.

Ainsi avec une possibilité d'agencement des trous traversants avec une distance entre les trous inférieure aux longueurs d'onde de la première gamme de longueurs d'onde, il est possible d'éviter les modes guidés photoniques dans le filtre optique qui pourraient réduire d'autant le taux de transmission. Le filtre optique d'un composant selon l'invention peut donc être à même de présenter un taux de transmission optimisé par rapport au filtre optique d'un composant de l'art antérieur.

Le matériau de remplissage dont l'indice de réfraction dans la première gamme de longueurs d'onde est avantageusement compris entre 2 et 4, et encore plus préférentiellement compris entre 2 et 3, voire entre 2,2 et 3.

Les premiers trous peuvent être régulièrement répartis dans la première couche métallique.

De cette manière, l'agencement des premiers trous dans la première couche métallique peut aisément être adapté afin de convenir aux contraintes d'un composant comportant une pluralité de structures aptes à absorber un rayonnement électromagnétique arrangées en matrice. On notera de plus, qu'avec un arrangement régulier des premiers trous dans la première couche métallique, il est aisé d'optimiser la distance entre les trous traversants.

La zone d'adaptation peu présenter un indice de réfraction dans la première gamme de longueurs d'onde qui est préférentiellement inférieur à 1,7, voire à 1,5 ou 1,2 et est idéalement sensiblement égale à 1.

Par « une première gamme de longueurs d'onde comprise dans la gamme des infrarouges et du visible », il doit être entendu ci-dessus et dans le reste de ce document que la première gamme de longueurs d'onde est comprises dans une gamme de longueurs d'onde incluant les longueurs d'onde du visible et des infrarouges. Ainsi la première gamme de longueurs d'onde peut tout aussi bien être totalement comprise dans la gamme du visible que dans la gamme des infrarouge voire inclure une partie de ses longueurs d'onde comprises dans la gamme du visible et le reste de ses longueurs d'onde comprises dans la gamme des infrarouges.

Dans chacun des trous traversants il peut être prévu un espacement entre la couche métallique et le matériau de remplissage.

Dans chacun des premiers trous traversants, il peut être prévu un espacement entre la couche métallique, ledit espacement étant configuré pour présenter un indice de réfraction dans la première gamme de longueurs d'onde inférieur à 2, préférentiellement à 1,7, voire 1,5, ceci soit en contenant un matériau d'interface présentant ledit indice de réfraction, soit en étant vide de matériau.

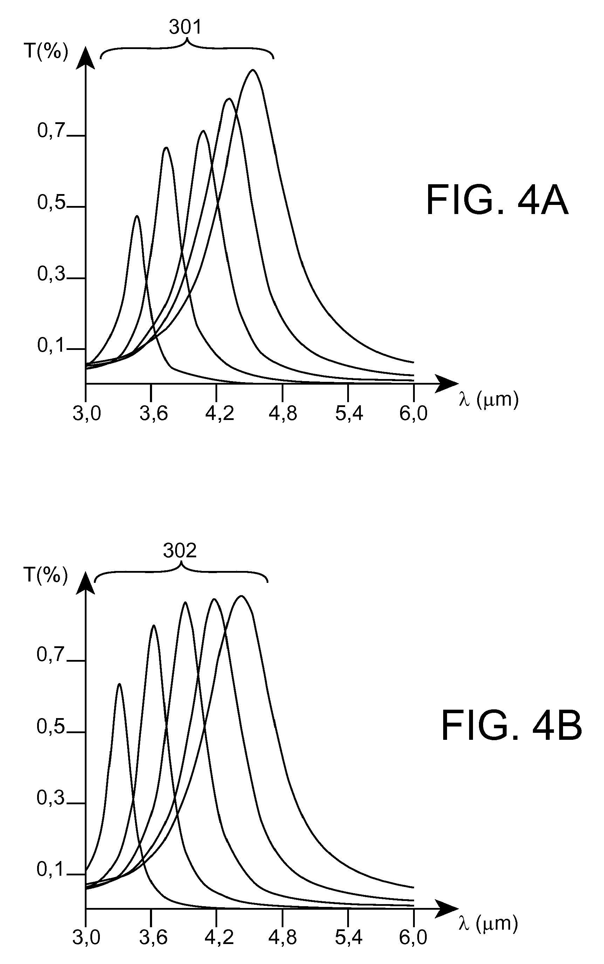

Avec un tel espacement entre la couche métallique et le matériau de remplissage il est possible de prévoir une zone d'interface présentant un indice de réfraction inférieur à 2, préférentiellement à 1,5, soit en laissant cet espacement vide soit en le remplissant avec un matériau adéquat. Une telle zone d'interface est particulièrement avantageuse. En effet, elle permet comme le montre les figures 4A et 4B de fournir un filtre optique avec un taux de transmission dans la première gamme de longueurs d'onde qui optimisé.

L'espacement peut être configuré pour présenter un indice de réfraction dans la première gamme de longueur d'ondes inférieur à 2, préférentiellement à 1,7, voire 1,5 en contenant un matériau d'interface, du matériau d'interface pouvant également être positionné entre le matériau de remplissage et la zone d'adaptation.

Le matériau de remplissage peut être encapsulé dans le matériau d'interface de manière à ce que le matériau d'interface fasse interface entre le matériau de remplissage et la couche de métal et soit positionné entre le matériau de remplissage et le support.

L'espacement peut être configuré pour présenter un indice de réfraction dans la première gamme de longueur d'ondes inférieur à 2, préférentiellement à 1,7, voire 1,5 en contenant un matériau d'interface, le matériau d'interface pouvant être sélectionné dans le groupe comportant les dioxydes de silicium, les nitrures de silicium.

De tels matériaux présentent des indices de réfraction dans le visible et les infrarouges particulièrement bas.

Chaque trou traversant l'espacement entre la couche métallique et le matériau de remplissage peut être vide de matériau.

Un tel vide de matériau est particulièrement avantageux pour obtenir un indice de réfraction le plus faible possible et ainsi optimiser au mieux le taux de réjection du filtre optique.

La zone d'adaptation peut être formée par un deuxième espace creux.

Le filtre optique peut comprendre en outre :

- une deuxième couche métallique, ladite deuxième couche métallique comprenant des deuxièmes trous traversants selon une configuration sensiblement identique aux premiers trous traversants de la première couche métallique, ces deuxièmes trous traversants contenant également du matériau de remplissage,

la première et la deuxième couche métallique étant séparées l'une de l'autre d'une distance d par un premier espace creux, la distance d respectant les inégalités suivantes :

$$\frac{\lambda}{6} \leq d \leq \frac{\lambda}{3}.$$

Les inventeurs ont découvert de manière étonnante qu'avec l'utilisation d'un espace creux ainsi dimensionné pour séparer la première et la deuxième couche métallique, la transmission du filtre optique est significativement supérieure à la multiplication des taux transmissions qui seraient obtenue pour un premier et un deuxième filtre optique comportant respectivement la première et la deuxième couche métallique. Ce résultat est lié, comme l'on découvert les inventeurs, à un couplage entre les résonances de chacune des couches métalliques. Le taux de rejection est ainsi optimisé sans que le taux de transmission soit significativement affecté.

La distance d séparant l'une de l'autre la première et la deuxième couche métallique peut être sensiblement

égale à $\frac{\lambda}{4}$.

Avec une telle configuration, le taux de transmission dans la première gamme de longueur d'onde est particulièrement optimisé.

Dans chacun des premiers et deuxièmes trous traversants l'espacement entre la couche métallique et le matériau de remplissage dans lequel il peut être compris un matériau d'interface, ledit espacement contenant un matériau d'interface présentant un indice de réfraction dans la première gamme de longueurs d'onde inférieur à 2, préférentiellement à 1,7, voire 1,5.

Un tel matériau d'interface permet de fournir un espacement entre la couche métallique et le matériau d'interface avec un indice de réfraction adéquat pour optimiser le un taux de transmission dans la première gamme de longueurs d'onde qui optimisé. De plus, contrairement à un espacement laissé vide, qui est donc soumis aux aléas du changement d'atmosphère, l'indice de réfaction d'un tel matériau d'interface présente l'avantage d'être stable dans le temps.

Le matériau de remplissage peut être un matériau sélectionné dans le groupe comportant les siliciums, les germaniums, les sulfures de zinc et les tellurures de plomb.

De tels matériaux permettent de fournir de fort indice de réfraction tout en étant parfaitement compatible avec les contraintes de fabrication de l'optoélectronique.

Le matériau de remplissage peut être un matériau cristallin ou polycristallin, tel qu'un silicium cristallin ou un germanium cristallin.

Le matériau de remplissage peut être un matériau amorphe, tel qu'un silicium a ou un germanium amorphe.

Le matériau de la première et de la deuxième couche métallique peut être un sélectionné dans le groupe comportant le cuivre, l'argent, l'or, l'aluminium, le tungstène, le titane et leurs alliages.

Le support comporte :

- un substrat dans lequel est aménagée au moins partiellement l'au moins une première structure, l'au moins une première structure présentant une surface active par laquelle la première structure absorbe le rayonnement électromagnétique,
- un capot disposé de manière à encapsuler la surface active de la première structure, la face du capot opposée à la surface active de la structure formant la face de détection du support.

De tel composant utilisant un capot, par exemple un bolomètre encapsulé, bénéficie particulièrement d'un filtre optique selon l'invention.

La répartition des premiers et deuxièmes trous traversants dans la première et la deuxième portion du filtre optique est identique,
et dans lequel les premiers et les deuxième trous traversants de respectivement la première et la deuxième portion sont dimensionnés pour que respectivement la première portion soit un filtre optique passe bande dans la première gamme de longueurs d'onde et que la deuxième portion soit un filtre optique passe bande dans la deuxième gamme de longueurs d'onde.

Une telle configuration du filtre optique ouvre les applications de mesures et d'imageries à plusieurs longueurs d'onde. En effet, avec un seul filtre, le composant peut comporter pour chaque portion une structure absorbante dédiée et ainsi mesurer avec ces structures les rayonnements électromagnétiques se trouvant dans la première et deuxième gamme de longueurs d'onde. On notera, de plus, que ceci est particulièrement avantageux lorsque ces structures absorbantes sont agencées sous la forme d'une matrice. En effet, le pas du réseau de trous étant constant, il peut être choisi comme étant une fraction unitaire du pas de la matrice de structures, c.a.d que le pas de la matrice est un multiple entier du pas de réseau. La conception et la fabrication d'un composant comportant ces structures s'en trouve particulièrement facilitée.

L'invention concerne également un procédé de fabrication d'un composant destiné à la détection d'un rayonnement électromagnétique dans une première gamme de longueurs d'onde comprise dans la gamme des infrarouges et du visible, ladite première gamme de longueurs d'onde étant centrée autour d'une longueur d'onde λ, le procédé comportant les étapes suivantes :

- fourniture d'un support comportant au moins une première structure destinée à la détection de rayonnement électromagnétiques et une face de réception pour recevoir le rayonnement électromagnétique,
- formation d'une zone d'adaptation recouvrant au moins en partie la face de réception du support et présentant un indice de réfraction dans la première gamme de longueurs d'onde qui est inférieur à 2,
- formation d'une couche métallique recouvrant la zone d'adaptation et comprenant des premiers trous traversants répartis et dimensionnés pour former une surface sélective en fréquence, chacun des premiers trous traversants contenant un matériau de remplissage dont l'indice de réfraction dans la première gamme de longueurs d'onde est supérieur à 2.

Le procédé peut comprendre en outre l'étape suivante de :

- formation d'une deuxième couche métallique, ladite deuxième couche métallique comprenant des deuxièmes trous traversants selon une configuration sensiblement identique aux premiers trous traversants de la première couche métallique, ces deuxièmes trous traversants contenant également du matériau de remplissage,

la première et la deuxième couche métallique étant séparées l'une de l'autre d'une distance d par un premier espace creux, la distance d respectant les inégalités suivantes :

$$\frac{\lambda}{6} \le d \le \frac{\lambda}{3}.$$

L'invention concerne également procédé de fabrication d'un composant destiné à la détection d'un rayonnement électromagnétique dans une première gamme de longueurs d'onde comprise dans la gamme des infrarouges et du visible, le procédé comportant les étapes suivantes :

- fourniture d'un substrat sacrificiel,
- formation d'une première couche métallique, la première couche métallique comprenant des premiers trous traversants régulièrement répartis et dimensionnés pour former une surface sélective en fréquence, chacun des premiers trous traversants contenant un matériau de remplissage dont l'indice de réfraction dans la première gamme de longueurs d'onde est supérieur à 2,
- formation d'une zone d'adaptation sur la couche métallique de manière à ce que la zone d'adaptation soit couverte par la première couche métallique, la zone d'adaptation présentant un indice de réfraction dans la première gamme de longueurs d'onde qui est inférieur à 2,
- fourniture d'un support comportant au moins une première structure apte à absorber un rayonnement électromagnétique et une face de réception pour recevoir le rayonnement électromagnétique ou d'une partie de support destinée à la formation d'un tel support et comportant la face de réception dudit support,
- report de l'ensemble zone d'adaptation, première couche métallique, deuxième couche métallique et substrat sacrificiel sur la face de réception de manière à ce que la zone d'adaptation recouvre au moins en partie la face de réception,
- suppression au moins en partie le substrat sacrificiel.

Le procédé peut en outre comporter entre l'étape de fourniture du substrat sacrificiel et l'étape de formation de la première couche métallique l'étape suivante :

- formation d'une deuxième couche métallique, ladite deuxième couche métallique comprenant des deuxièmes trous traversants régulièrement répartis et dimensionnés pour former une surface sélective en fréquence, ces deuxièmes trous traversants contenant un matériau de remplissage dont l'indice de réfraction dans la première gamme de longueurs d'onde est supérieur à 2,

après l'étape de formation de la deuxième et de la première couche métallique, la première et la deuxième couche métallique étant séparées l'une de l'autre d'une distance d par un premier espace creux, la distance d respectant les inégalités suivantes :

$$\frac{\lambda}{6} \leq d \leq \frac{\lambda}{3}.$$

De tels procédés de fabrication permettent de fabriquer un composant bénéficiant des avantages liés à l'invention.

Lors de l'étape de formation de la couche première couche métallique, les premiers trous peuvent être régulièrement répartis dans la première couche métallique.

L'étape de formation de la deuxième couche métallique peut comporter les sous-étapes suivantes :

- formation d'une couche sacrificielle sur la première couche métallique à l'opposé de la zone d'adaptation, la couche sacrificielle présentant l'épaisseur d
- dépôt et structuration d'une deuxième couche métallique sur la couche sacrificielle à l'opposé de la première couche sacrificielle, ladite deuxième couche métallique comprenant des deuxièmes trous traversants selon une configuration sensiblement identique aux premiers trous traversants de la première couche métallique, ces deuxièmes trous traversants contenant également du matériau de remplissage,
- suppression de la couche sacrificielle de manière à former un premier espace creux séparant la première et la deuxième couche métallique l'une de l'autre d'une distance d.

L'étape de formation de la première couche métallique et de l'étape de formation de la deuxième couche métallique peut comporter les sous-étapes suivantes :

- dépôt du matériau de remplissage de manière à délimiter avec le matériau de remplissage au moins partiellement les premiers trous traversants de la première couche métallique,
- dépôt d'une couche de matériau métallique de manière à remplir les espaces laissés libres par le matériau de remplissage pour ainsi former la première couche métallique.

Une telle étape de formation de la première couche métallique est particulièrement avantageuse pour fournir la couche métallique puisqu'elle utilise des étapes parfaitement compatibles avec les contraintes de fabrication de l'optoélectronique.

Lors de l'étape de dépôt du matériau de remplissage, le dépôt peut être réalisé de manière à ce que le matériau de remplissage soit entouré de matériau d'interface ceci pour définir lors du dépôt de matériau métallique un espacement entre la première ou deuxième couche de métallique et le matériau de remplissage.

Un tel procédé de fabrication permet de fournir un composant bénéficiant d'un taux de transmission optimisé.

## BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :

- les figures 1A et 1B illustrent schématiquement un composant selon un premier mode de réalisation de l'invention avec en figure 1A une vue en coupe et en figure 1B une vue de dessus illustrant les trous traversants ménagés dans la couche métallique du composant,
- les figures 2A à 2C illustrent respectivement trois exemples de formes de premiers trous traversants pour une première couche métallique d'un composant selon l'invention,
- les figures 3A à 3H illustrent schématiquement les principales étapes de fabrication du composant illustré sur les figures 1A à 1B,
- les figures 4A et 4B illustrent graphiquement l'amélioration apportée par l'utilisation d'un matériau d'interface disposé entre la couche métallique et un matériau de remplissage avec respectivement en figure 4A les spectres de transmission de filtres optiques selon l'invention ne comportant pas un tel matériau de remplissage et en figures 4B ceux pour des filtres optiques selon l'invention comportant un tel matériau de remplissage,
- la figure 5 illustre des spectres de transmission pour des filtres optiques de composants selon une réalisation pratique selon l'invention avec quatre dimensionnements différents des premiers trous traversants de la première couche métallique,
- les figures 6A et 6B illustrent schématiquement un composant selon un deuxième mode de réalisation de l'invention avec en figure 6A une vue en coupe et en figure 6B une vue de dessus illustrant les trous traversants ménagés dans la couche métallique du composant,
- la figure 7 illustre un composant selon une variante du premier mode de réalisation illustrée sur les figures 1A et 1B dans laquelle la zone d'adaptation est fournie par un deuxième espace creux,
- la figure 8 illustre un composant selon un deuxième de mode de réalisation dans lequel il prévu une deuxième couche métallique formant une surface sélective en fréquence,
- les figures 9A à 9J illustrent les étapes de fabrication d'un composant selon le deuxième mode de réalisation comportant une conception similaire à celle du composant selon la variante du premier mode de réalisation illustré sur la figure 7,

- la figure 10 illustre une vue de dessus d'un composant tel qu'illustré sur la figure 9J,
- les figures 11A et 11B illustrent le bénéfice d'une séparation d'une première et une deuxième couches métalliques formée par un espace creux au lieu d'une couche de matériau transparent, la figure 11A illustrant les spectres de transmission de composants selon l'invention dans lesquelles l'espace creux a été remplacée par une couche de silice et la figures illustrant les spectres de transmission de composants selon l'invention,
- les figures 12A et 12B illustrent schématiquement les composants dont les spectres de transmissions sont respectivement représentés sur la figure 11A et la figure 11B,
- la figure 13 illustre schématiquement un composant selon une variante de l'invention dans lequel le composant comporte un filtre optique comprenant une première et une deuxième portion dans lesquelles le filtre est la respectivement un filtre passe bande dans une première et une deuxième gamme de longueurs d'onde,
- les figures 14A et 14B illustrent schématiquement un exemple pratique de mise en oeuvre d'un composant selon l'invention adapté pour permettre la détection dans quatre gammes de longueurs d'onde différentes, la figure 14A illustrant une vue en coupe schématique au niveau d'un premier trou traversant, la figure 14B illustrant par une vue de dessus la forme de ce même premier trou traversant,
- la figure 15 illustre les spectres de transmission calculés pour les différentes portions d'un filtre optique d'un composant selon l'exemple pratique de mise en oeuvre illustré sur les figures 14A et 14B.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

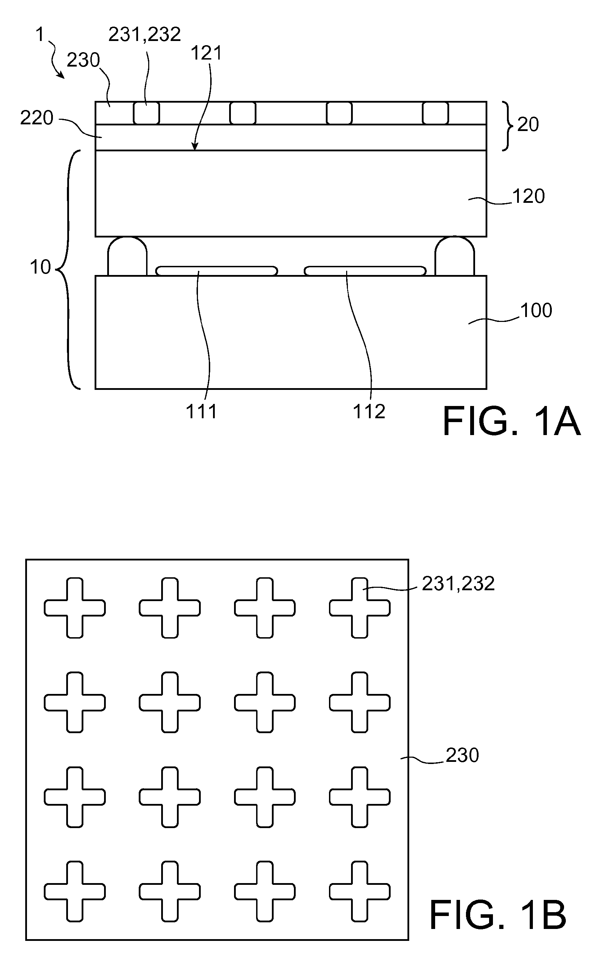

Les figures 1A et 1B illustrent un composant 1 selon un premier mode de réalisation mettant l'avantage d'une surface sélective en fréquence présentant des trous traversants contenant un matériau de remplissage 232 dont l'indice de réfraction dans une première gamme de longueurs d'onde est supérieur à 2,

Un tel composant 1 selon ce premier mode est destiné à la détection et/ou la mesure d'un rayonnement électromagnétique dans une première gamme de longueurs d'onde comprise dans la gamme des infrarouges et du visible.

Un tel composant 1 selon l'invention est plus particulièrement dédié à la détection de rayonnement dans une première gamme de longueurs d'onde comprise dans la gamme des infrarouges. On notera que la gamme des infrarouges est divisée en trois sous-domaines que sont la gamme du proche infrarouge comprise entre 1 et 3 $\mu$m, la gamme de l'infrarouge moyen comprise entre 3 et 5 $\mu$m et l'infrarouge lointain correspondant aux longueurs d'onde comprises entre 8 et 14 $\mu$m.

Un tel composant 1 comporte :

- un support 10 comportant une première et une deuxième structure 111, 112 toutes deux aptes à absorber un rayonnement électromagnétique et une face de réception 121 pour recevoir le rayonnement électromagnétique,
- un filtre optique 20 du type passe bande dans la première gamme de longueurs d'onde, le filtre optique étant disposé sur la face de réception du support 10 de manière à filtrer le rayonnement électromagnétique transmis au support 10.

Le support 10 comporte, comme illustré sur la figure 1A :

- un substrat 100 dans lequel sont aménagées au moins partiellement la première et la deuxième structure 111, 112,
- la première et la deuxième structure 111, 112 comportant chacune une surface active pour absorber le rayonnement électromagnétique filtré, ladite surface active étant supportée par le substrat 100 sur la figure 1A,
- un capot 120 disposé de manière à encapsuler les surfaces actives des première et deuxième structures 111, 112, la face du capot opposée aux surfaces actives des structures 111, 112 formant la face de réception 121 du support 10.

Le substrat 100 est un substrat semiconducteur classique dans lequel est aménagée l'électronique de lecture des première et deuxième structures 111, 112. Classiquement le substrat 100 peut être un substrat en silicium.

La première et la deuxième structure 111, 112, sont toutes deux des structures du type bolomètre. La première et la deuxième structure 111, 112 comportent toutes deux un circuit de lecture, non illustré, et une surface active par laquelle elles sont référencées sur la figure 1A. La surface active de chacune de la première et la deuxième structure 111, 112 est supportée par le substrat 100 et est disposée de manière à recevoir le rayonnement électromagnétique reçu par la face de réception 121.

De telles structures 111, 112 étant connues de l'homme du métier, elles ne sont pas décrites plus précisément dans ce document.

Le capot 120 permet d'encapsuler les surfaces actives des première et deuxième structures 111, 112 de manière à définir une atmosphère protectrice pour les surfaces actives de ces dernières. Le capot 120 est réalisé dans un matériau au moins partiellement, et préférentiellement totalement, transparent dans la première gamme de longueurs d'onde. Ainsi dans le cadre du premier mode de réalisation illustré sur la figure 1A et une première gamme de longueurs d'onde comprise dans la gamme des infrarouges, le capot 120 peut être formé par un substrat silicium. En variante, le capot 120 peut également être en germanium.

Le capot présente un indice de réfraction dans la première gamme de longueurs d'onde des infrarouges qui est généralement compris entre 2 et 4, voire entre 2,5 et 3,5 ou encore 2,6 et 3.

Le capot 120 présente la face de réception 121 du support 10.

Le filtre optique 20 est disposé sur le support en contact avec la face de réception 121.

Le filtre optique 20 comporte :

- une couche de collage 210,
- une zone d'adaptation 220 recouvrant au moins en partie la face de réception du support 20, la zone d'adaptation 220 étant fixée à la face de réception 121 au moyen de la couche de collage 210,
- une première couche métallique 230 recouvrant la zone d'adaptation 220 et comprenant des premiers trous traversants 231 régulièrement répartis et dimensionnés pour que la première couche métallique 230 forme une surface sélective en fréquence.

La couche de collage 210 est réalisée dans un matériau au moins partiellement transparent dans la première gamme de longueurs d'onde et préférentiellement transparent dans cette même première gamme de longueurs d'onde. La couche de collage 210 présente un indice de réfraction inférieur à celui du capot. Ainsi le matériau de la couche de collage 210 peut être un matériau présentant un indice de réfraction inférieur à 2, voire inférieur à 1,7.

Ainsi, ce matériau de la couche de collage 210 peut être, par exemple, un polymère époxyde tel que le polymère époxyde commercialisé par EPO-TEK™ sous la référence EPO-TEK™ 360. En effet, un tel matériau de la couche de collage 210 présente un indice de réfraction dans le visible sensiblement égal à 1,5.

La couche de collage 210 peut être relativement épaisse et ainsi être comprise entre 100 nm et 1,5 $\mu$m, voire entre 300 nm et 1 $\mu$m. Classiquement, la couche de collage peut être, par exemple, d'épaisseur de 300 nm.

La couche de collage 210 permet de fixer la zone d'adaptation 220 à la face de réception 121 du support 10. Ainsi la zone d'adaptation 220 recouvre la face de réception 121 du support 10.

La zone d'adaptation 220 se présente selon une forme de couche et peut ainsi également être également dénommée « couche d'adaptation ». La zone d'adaptation est réalisée dans un matériau au moins transparent dans la première gamme de longueurs d'onde et préférentiellement transparent dans cette même première gamme de longueurs d'onde. La zone d'adaptation 220, de manière à fournir une symétrie d'indice de réfraction autour de la première couche métallique 230 formant une surface sélective en fréquence, présente un indice de réfraction inférieur ou égal à 2 et préférentiellement inférieur à 1,7, ou 1,5 voire inférieur à 1,2 ou encore sensiblement égal à 1.

Ainsi, la zone d'adaptation 220 peut être réalisée dans un matériau sélectionné dans le groupe comportant le dioxyde de silicium $SiO_2$ et le nitrure de silicium $Si_3N_4$. L'épaisseur de la zone d'adaptation 220 est comprise entre 50 nm et 1,5 $\mu$m et préférentiellement entre 150 nm et 600 nm.

Par exemple, l'épaisseur de la zone d'adaptation 220 peut être comprise entre 250 et 350 nm pour une première gamme de longueurs d'onde comprise dans la gamme du moyen infrarouge et entre 550 et 650 nm pour une première gamme de longueurs d'onde comprise dans la gamme de l'infrarouge lointain.

La première couche métallique 230 recouvre la zone d'adaptation 220.

La première couche métallique 230 présente une épaisseur supérieure à l'épaisseur de peau de manière à assurer que la première couche métallique soit opaque vis-à-vis du rayonnement électromagnétique. Ainsi l'épaisseur de la première couche métallique 230 est supérieur ou égale à $\frac{\lambda_r}{100}$ avec $\lambda_r$ la borne inférieure de la première gamme de longueurs d'onde. Ainsi pour une application dans la gamme des infrarouges, c'est-à-dire une gamme de longueurs d'onde supérieure 1 $\mu$m, l'épaisseur de la première couche métallique est supérieure ou égale à 100 nm.

La première couche métallique est préférentiellement réalisée dans un métal sélectionné dans le groupe comportant le cuivre, l'argent, l'or, l'aluminium, le tungstène, le titane et leurs alliages.

La première couche métallique 230 comporte des premiers trous traversants 231 de manière à former une surface sélective en fréquence. La première couche métallique comportant une première et une deuxième face, la première face étant celle en contact avec la zone d'adaptation, chaque trou 231 traversant débouche, par définition, dans chacune de la première et la deuxième face de la première couche métallique 230. Les premiers trous traversants 231 sont répartis régulièrement sur la première couche métallique 230 pour former un réseau régulier de trous traversants tel qu'un réseau carré ou un réseau hexagonal. Le pas du réseau de premiers trous traversants 231, ou période, est préférentiellement choisi comme étant inférieur à la borne inférieure en longueur de la première gamme de longueurs d'onde ceci de manière à éviter tout mode guidé photonique dans le filtre optique 20. Ainsi, pour une première gamme de longueurs d'onde dans la gamme du moyen infrarouge le pas du réseau de premiers trous traversants 231 peut être choisi comme étant inférieur à 3 μm.

Selon une variante de l'invention non illustrée, les premiers trous traversants peuvent être répartis dans la première couche métallique 230 de manière irrégulière. Selon cette variante de l'invention, la distance entre chaque premier trou traversant 231 et le premier trou traversant 231 qui lui est le plus proche qui est préférentiellement choisie inférieure à la borne inférieure en longueur de la première gamme de longueurs d'onde ceci de manière à éviter tout mode guidé photonique dans le filtre optique 20.

La figure 1B illustre un exemple d'un tel arrangement des premiers trous traversants 231. Le dimensionnement des premiers trous traversants 231, selon le principe des surfaces sélectives en fréquence, sont conformés et dimensionnés de manière à définir la première gamme de longueurs d'onde. Ainsi, les premiers trous traversants 231 illustrés sur la figure 1B sont des trous en forme de croix.

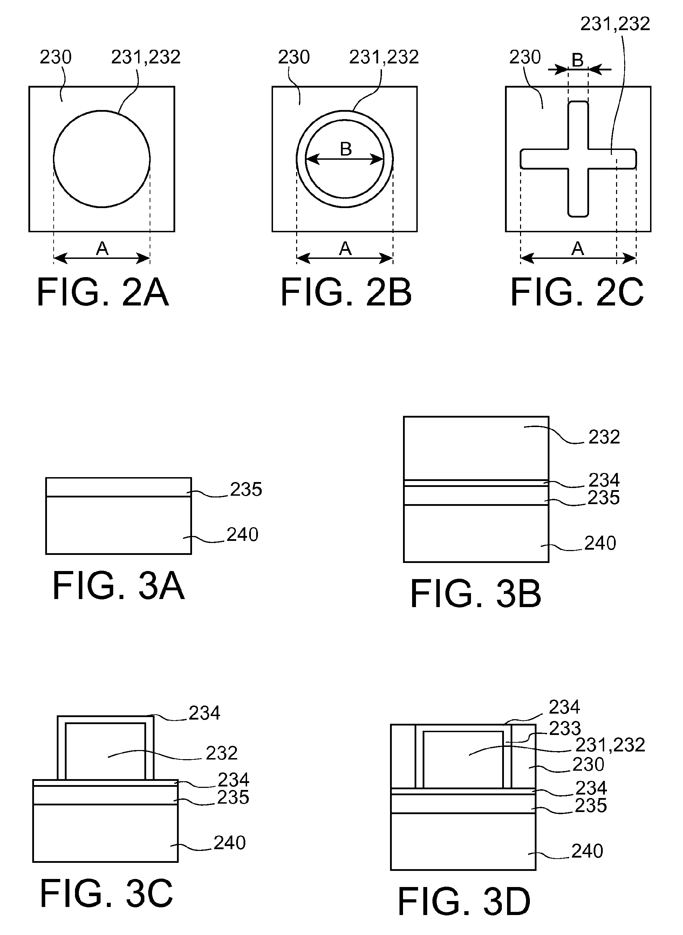

Bien entendu, l'invention ne se limite pas à cette seule forme de premiers trous traversants 231. Ainsi, les premiers trous traversants 231 peuvent aussi bien être des trous circulaires, qu'annulaires ou en croix, comme illustré sur les figures 2A à 2C ou peuvent être de toutes autres formes, telle que par exemple une forme carrée ou hexagonale.

En fonction de la forme des premiers trous traversants 231, les trous premiers traversants peuvent présenter deux dimensions latérales A et B, l'une A étant une dimension dite maximale et l'autre B étant une dimension dite minimale. On peut ainsi voir sur la figure 2A, que les trous circulaires présentent une forme isotrope, ne comporte qu'une dimension caractéristique A tandis que les trous de forme annulaires et en croix présentent chacune une dimension maximale A et une dimension minimale B. Ainsi, dans le cas d'une forme annulaire, les dimensions maximale et minimale correspondent respectivement, comme illustré sur la figure 2B aux diamètres extérieur et intérieur de l'anneau. Pour une forme en croix, telle qu'illustrée sur la figure 2C, les dimensions maximale A et minimale B correspondent respectivement à la largeur de la croix et à l'épaisseur des branches de la croix. La première gamme de longueurs d'onde dépend directement de ces deux dimensions latérales A et B.

Ainsi, par exemple, la dimension maximale A peut être choisie entre 400 et 1400 nm pour une première gamme de longueurs d'onde comprise dans la gamme du moyen infrarouge et entre 800 et 2400 nm pour une première gamme de longueurs d'onde comprise dans la gamme des infrarouges lointains. De même, la dimension minimale B peut-elle être choisie entre 300 et 800 nm pour une première gamme de longueurs d'onde comprise dans la gamme du moyen infrarouge et entre 600 et 2000 nm pour une première gamme de longueurs d'onde comprise dans la gamme des infrarouges lointains. Bien entendu, la dimension minimale B est par définition choisie comme inférieure à la dimension maximale A.

Plus généralement, les dimensions latérales A et B des premiers trous traversants peuvent être aisément calculées par un homme du métier à partir de calculs de routine. De tels calculs de routine sont parfaitement à la portée d'un homme du métier ayant eu connaissance de la présente divulgation.

Il est à noter que le rapport de la dimension minimale B sur la dimension maximale A permet de définir la largeur du pic de transmission et donc de la première gamme de longueurs d'onde. Un rapport B sur A faible permet ainsi d'obtenir des pics plus étroits tandis qu'un rapport B sur A s'approchant de 1 permet de maximiser la largeur des pics, tous autres paramètres restant égaux.

Chaque trou traversant 231 contient un matériau de remplissage 232 dont l'indice de réfraction dans la première gamme de longueurs d'onde est supérieur à 2. Ce matériau de remplissage 232 présente préférentiellement un indice de réfraction dans la première gamme de longueurs d'onde qui est supérieur à 3. Le matériau de remplissage 232 peut être choisi dans le groupe comportant le silicium aSi sous forme amorphe, le germanium aGe sous forme amorphe et le tellurure de plomb PbTe.

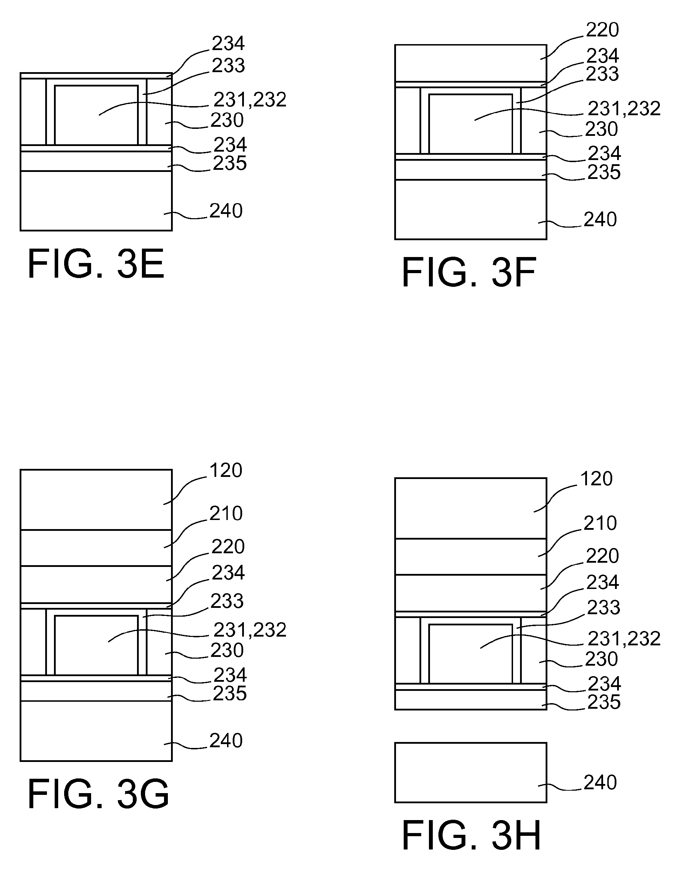

Selon une caractéristique optionnelle de l'invention, notamment illustrée sur la figure 3H, il peut être prévu dans chacun des premiers trous traversants 231 un espacement 233 entre la première couche métallique 230 et le matériau de remplissage 232. Un tel espacement 233 permet de créer, entre la première couche métallique 230 et le matériau de remplissage 232, une interface à faible indice de réfraction relativement à l'indice de réfraction du matériau de remplissage 232.

Pour définir une telle interface à faible indice de réfraction, selon une première variante de cette caractéristique optionnelle, l'espacement 233 entre la première couche métallique 230 et le matériau de remplissage 232 peut contenir un matériau d'interface 234. Ce matériau d'interface 234 est donc choisi comme présentant un indice de réfraction dans la première gamme de longueurs d'onde inférieur à celui du matériau de remplissage 232, préférentiellement inférieur à 2, voire à 1,5 ou à 1,2.

Le matériau d'interface 234 peut ainsi être sélectionné dans le groupe comportant le dioxyde de silicium $SiO_2$ et le nitrure de silicium $Si_3N_4$. Le matériau d'interface 234 peut également être identique à celui de la zone d'adaptation 220.

Selon cette variante et comme illustré sur la figure 3H, le matériau d'interface 234 peut également faire interface entre le matériau de remplissage 232 et la zone d'adaptation. De la même façon, le matériau d'interface 234 peut également complétement encapsuler le matériau de remplissage 232. Selon cette possibilité, telle qu'illustrée sur la figure 3H, la première couche métallique 230 peut également être recouverte du matériau d'interface 234 à la fois sur sa face en regard de la zone d'adaptation 220, le matériau d'interface 234 faisant alors interface entre la zone d'adaptation et la première couche métallique 220, et sur sa face opposée à la zone d'adaptation 220. Il est à noter que dans ce cas, le matériau d'interface 234 présente préférentiellement un indice de réfraction proche de 1, c'est-à-dire inférieur à 2, préférentiellement inférieur à 1,7 ou 1,5 voire 1,2 et avantageusement égal à 1, pour limiter la rupture d'indice au niveau de chacune des faces de la première couche métallique 230.

Selon une deuxième variante de cette caractéristique optionnelle, non illustrée, l'espacement 233 entre le matériau de remplissage 232 et la première couche métallique 230 peut être vide de matériau. De cette manière, l'espacement 233 présente l'indice de réfraction de l'air dans la première gamme de longueurs d'onde, c'est-à-dire un indice de réfraction égal à 1.

On peut noter que selon une autre caractéristique optionnelle non illustrée sur la figure 1A et présentée sur la figure 3H, la première couche métallique 230 peut être recouverte, sur sa face opposée à la zone d'adaptation, d'une couche d'accroche, telle qu'une couche de dioxyde de silicium SiO$_2$ ou de nitrure de silicium Si$_3$N$_4$. Une telle couche d'accroche, formée sur la figure 3H par le matériau d'interface 234 présente préférentiellement un indice de réfraction proche de 1, c'est-à-dire inférieur à 2, préférentiellement inférieur à 1.7 ou 1,5, voire 1,2, et avantageusement égal à 1.

Les figures 3A à 3H illustrent un procédé de fabrication d'une structure selon le premier mode de réalisation l'invention dans laquelle la zone d'adaptation 220 est fixée au capot 120 au moyen d'une couche de colle 210. Un tel procédé comporte les étapes suivantes :

- fourniture d'un substrat sacrificiel 240,
- formation sur le substrat sacrificiel 240 d'une couche diélectrique 235, telle qu'une couche de dioxyde de silicium SiO$_2$, telle qu'illustrée sur la figure 3A,
- dépôt d'une première couche d'accroche réalisée dans le matériau d'interface 234, cette couche pouvant faire, par exemple, 35 nm d'épaisseur,
- dépôt sur la première couche d'interface d'une couche de matériau de remplissage 232, tel qu'un silicium sous forme amorphe, comme cela est illustré sur la figure 3B,
- gravure sélective de la couche de matériau de remplissage 232 de manière à définir la forme des premiers trous traversants 231 de la première couche métallique 230,
- dépôt sélectif de matériau d'interface 234 sur le matériau de remplissage 232 de manière à encapsuler le matériau de remplissage 232, comme cela est illustré sur la figure 3C,
- dépôt d'un métal, tel que du cuivre en contact avec la surface de la première couche d'interface dans les espaces laissés libre par le matériau de remplissage 232 pour former la première couche métallique 230, tel qu'illustré sur la figure 3D,
- dépôt d'une deuxième couche de matériau d'interface 234, telle qu'une couche de nitrure de silicium, comme cela est illustré sur la figure 3E,
- dépôt de la zone d'adaptation 220 en contact avec la deuxième couche de matériau d'interface, tel qu'illustré sur la figure 3F,
- fourniture du capot 120, le capot 120 étant une partie de support 10 destinée à la formation d'un tel support 10 et comportant la face de réception 121 dudit futur support 10,
- fixation de la zone d'adaptation 220 par sa face opposée à la première couche métallique 230 sur le capot 120 au moyen d'une couche de collage 210, comme cela est illustré sur la figure 3G,
- suppression du substrat sacrificiel 240, comme illustré sur la figure 3H.

Ainsi, après report du capot 120 sur le reste du support 10 de manière à former le composant 1, le filtre optique 20 formé par la zone d'adaptation 220 et la première couche métallique 230 se trouve en contact avec la face de réception 121 du support 10 au moyen de la couche de collage 210.

Avantageusement l'épaisseur de la couche diélectrique 235 est inférieure à l'épaisseur de la zone d'adaptation 220 divisé par 3.

De manière encore plus préférentielle, la coche diélectrique 235 est inférieure à 100 nm voire très inférieure à 100 nm, c'est-à-dire inférieure à 50 nm voire 20 nm. En effet, les inventeurs ont observé que de manière surprenante et à l'inverse de l'entendement de l'homme du métier, la section efficace est particulièrement importante avec un tel dimensionnement de la couche diélectrique 235.

On peut noter qu'en variante de de ce premier mode de réalisation de l'invention, lors de ce procédé de fabrication, le substrat sacrificiel peut ne pas être supprimé ou l'être que partiellement (c'est-à-dire être aminci). Selon cette variante, il est alors préférable que les épaisseurs cumulées de couche diélectrique 235 et du substrat 240 soit du même ordre de grandeur que l'épaisseur de la zone d'adaptation 220.

Selon une variante de ce premier mode de réalisation, il est également envisageable que l'étape de dépôt de la couche diélectrique 235 soit omise. Selon cette variante, il est également envisageable que lors de l'étape de suppression du substrat sacrificiel 240, la couche d'accroche soit également supprimée.

L'étape de dépôt de métal pour former la première couche métallique 230 peut être une étape selon le procédé damascène. Une telle étape de dépôt selon le procédé damascène comporte les sous-étapes suivantes :

- dépôt d'une première couche de nucléation de métal, par exemple par pulvérisation cathodique,
- dépôt du reste de la première couche métallique par un dépôt électrolytique,
- recuit thermique,
- polissage de la première couche métallique de manière à supprimer le métal déposé sur le matériau de remplissage 232.

Les figures 4A et 4B illustrent des exemples de spectre en transmission de respectivement :

- des filtres optiques 20 selon l'invention dans lequel il n'est pas prévu d'espacement 233 entre la première couche métallique 230 et le matériau de remplissage 232, les premiers trous traversants 231 étant donc complétement remplis de matériau de remplissage 232 tel que cela est illustré sur la figure 1A
- des filtres optiques 20 selon l'invention et pour lesquels il est prévu un espacement 233 entre le matériau de remplissage 232 et la première couche métallique 230, ce dernier espace 231 étant rempli d'un nitrure de silicium $Si_3N_4$ en tant que matériau d'interface 234, tel que cela est illustré sur la figure 3H.

Chacune de ces figures 4A et 4B illustrent le taux de transmission en pourcentage en fonction de la longueur d'onde en micromètre.
Bien entendu, de manière à permettre une comparaison entre les spectres en transmission des figures 4A et 4B, le dimensionnement des filtres optiques 20 utilisés pour effectuer les spectres de la figure 4B est identique à ceux utilisés pour effectuer les spectres de la figure 4A. On note ainsi une forte augmentation du taux de transmission avec la présence du matériau d'interface 234 pour les filtres optiques 20 adaptés pour les gammes de longueurs d'onde d'un moyen infrarouge, ceux des infrarouges lointains étant peu affectés.
Ainsi l'utilisation d'un espacement 233 entre la première couche métallique 230 et le matériau de remplissage 232 permet d'augmenter significativement le taux de transmission pour les gammes de longueurs d'onde dans le moyen et le proche infrarouge.
Concernant le dimensionnement optimal d'un tel espacement 233, le tableau 1 suivant illustre les pertes induites par la couche métallique pour un rayonnement électromagnétique dans la gamme de longueur d'onde ceci pour différentes épaisseurs de l'espacement 233. Pour ces calculs, la structure simulée est celle illustrée sur la figure 1A avec les caractéristiques suivantes :

- la couche métallique 220 est une couche de cuivre de 200 nm d'épaisseur,
- le matériau de remplissage 232 est du silicium amorphe d'indice de réfraction dans la première gamme de longueurs d'onde de 3,5,

- le matériau d'interface 234 est du nitrure de silicium d'indice de réfraction dans la première gamme de longueurs d'onde de 1,9,
- l'épaisseur de la couche d'interface 234 est variée entre 0 et 100 nm,
- les trous traversant 231 sont du type de ceux illustrés sur la figure 2B avec la dimension A, c'est-à-dire le diamètre extérieur, égal à 900 nm, et la dimension B, c'est-à-dire le diamètre intérieur, égal à 250 nm,
- la zone d'adaptation 220 est réalisée en dioxyde de silicium d'indice de réfraction dans la première gamme de longueurs d'onde de 1,5 et présente une épaisseur de 200 nm,

Il ressort de ce tableau, en concordance avec les spectres en transmission des figures 4A et 4B, que l'espacement 233 permet de diminuer les pertes dans la première gamme de longueur d'onde induites par la première couche métallique.

**Tableau 1 :** Perte induite par la couche métallique dans la gamme de longueur en fonction de l'épaisseur de l'espacement 233 entre la couche métallique 230 et le matériau de remplissage 232

| Épaisseur (nm) | Perte en dB/µm |
|---|---|
| 0 | 0,2227 |
| 20 | 0,1790 |
| 50 | 0,1651 |
| 100 | 0,1733 |

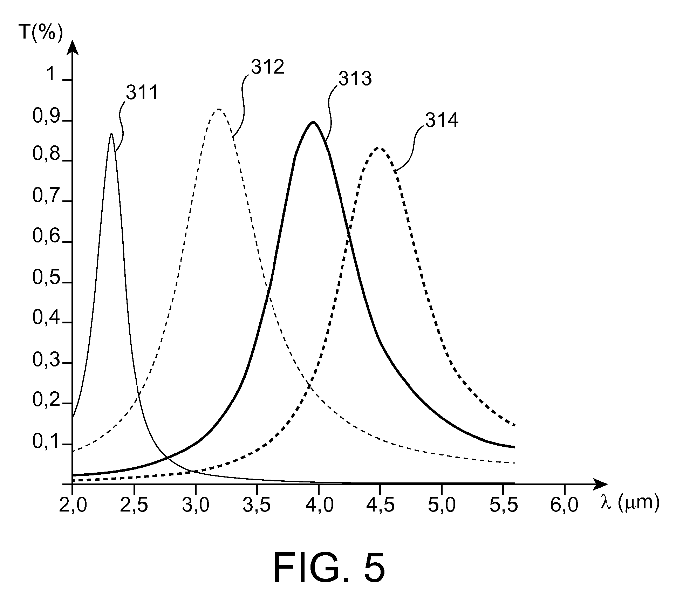

Afin d'illustrer de manière pratique le principe de l'invention, la figure 5 montre graphiquement plusieurs spectres en transmission 311, 312, 313, 314 de filtres optiques 20 selon une réalisation pratique de l'invention.
Cette réalisation pratique de l'invention est conforme au composant 1 illustré sur la figure 1A pour laquelle les premiers trous traversants 231 sont de forme annulaire, telle qu'illustrée sur la figure 2B. Les caractéristiques du composant 1 selon cette réalisation pratique sont les suivantes :

- un capot 120 en silicium cristallin Si d'indice de réfraction dans la première gamme de longueurs d'onde d'environ 3,5,
- une zone d'adaptation 220 de 200 nm en dioxyde de silicium $SiO_2$ et d'indice de réfraction dans la première gamme de longueurs d'onde d'environ 1,5,
- une première couche métallique 230 en cuivre de 100 nm d'épaisseur,
- des premiers trous traversants 231 répartis selon un réseau carré dont le pas est de 1500 nm
- le matériau de remplissage est du silicium sous une forme amorphe aSi d'indice de réfraction dans la première gamme de longueurs d'onde d'environ 3,5,
- un matériau d'interface en nitrure de silicium $Si_3N_4$

d'indice de réfraction dans la première gamme de longueurs d'onde de 1,9.

Les premiers trous traversants 231 des filtres optiques 20 correspondant au premier, deuxième, troisième et quatrième spectre en transmission 311, 312, 313, 314 présentent respectivement une dimension maximale A de 520, 815, 815 et 720 nm. La dimension minimale B respective des premiers trous traversants 231 des filtres optiques 20 correspondant au premier, deuxième, troisième et quatrième spectre en transmission 311, 312, 313, 314 est respectivement égale à 0, 0, 420 et 590 nm. Bien entendu une dimension minimale B nulle correspond à un trou traversant dont la transversale est en forme de disque telle qu'illustrée sur figure 2A.

Ces mêmes spectres en transmission peuvent également être obtenus avec un pas de réseau des premiers trous traversants 231 égal à 1 μm. Dans ce cas, la dimension maximale A respective des premiers trous traversants 231 des filtres optiques 20 correspondant au premier, deuxième, troisième et quatrième spectre en transmission 311, 312, 313, 314 est respectivement égale à 520, 770, 770 et 750 nm. Concernant la dimension minimale B, celle-ci est égale pour les premiers trous traversants 231 des filtres optiques 20 correspondant au premier, deuxième, troisième et quatrième spectre en transmission 311, 312, 313, 314 respectivement à 0, 250, 460 et 570 nm.

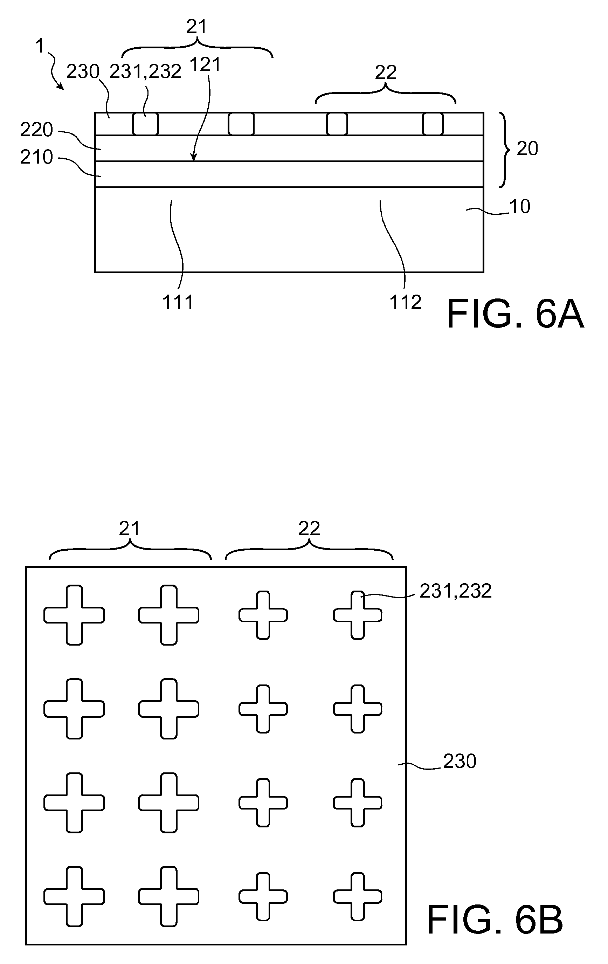

Les figures 6a et 6b illustrent un composant selon un deuxième mode de réalisation de l'invention dans lequel le filtre optique 20 présente une première portion 21 dans laquelle le filtre est un filtre passe bande dans la première gamme de longueurs d'onde et une deuxième portion 22 dans laquelle le filtre est un filtre passe bande dans une deuxième gamme de longueurs d'onde. Un composant 1 selon ce deuxième mode de réalisation se différencie d'un composant 1 selon le premier mode de réalisation en ce que le support 10 est constitué d'un unique substrat dans lequel une première et deuxième structure 111, 112 sont aménagées et en ce que le filtre optique 20 est configuré pour permettre de filtrer deux gammes de longueurs d'onde.

Le support 10 est dans ce mode de réalisation un substrat semiconducteur ou comportant au moins une couche semiconductrice, tel que par exemple un substrat silicium ou un substrat en semiconducteur III-V ou encore en semiconducteur II-VI.

Le support 10 comporte une première et une deuxième face, la première face formant face de réception 121 pour recevoir le rayonnement électromagnétique.

La première et la deuxième structure 111, 112 sont toutes deux des structures du type photodiode. Ainsi la première et deuxième structure 111, 112 peuvent être aussi bien des photodiodes du type PIN, c'est-à-dire comportant une zone intrinsèque, que des photodiodes à avalanche. Selon une autre possibilité de l'invention la première et la deuxième structure 111, 112 peuvent également être des photodétecteurs du type barrière également connus sous les dénominations nBn et pBp.

Chacune des structures 111, 112 présentent une surface active par laquelle la structure absorbe le rayonnement électromagnétique. Cette surface active de chacune des structures 111, 112 se trouve à la surface de la face de réception 121 du support 10. De cette manière, dans ce deuxième mode de réalisation, la surface active de chacune des structures 111, 112 est en contact avec le filtre optique 20. Avec une telle configuration, l'association entre les première et deuxième portions 21, 22 avec respectivement la première et la deuxième structure 111, 112 est particulièrement facilitée.

Contrairement au composant 1 selon le premier mode de réalisation, le placement du filtre optique 20 sur la face de réception du support se fait au moyen d'une couche de collage 210, la couche de collage 210 faisant alors interface entre la couche d'adaptation 220 et la face de réception 121.

Les trous traversant 231 sont ménagés dans la première et la deuxième portion 21, 22 du filtre optique 20 selon un réseau carré avec un pas constant. Ainsi, la première et la deuxième portion 21, 22 du filtre optique 20 se distingue uniquement de par la forme des trous traversants 231 qu'elles contiennent. Le dimensionnement des trous traversants 231 de la première portion 11, notamment leurs dimensions maximale A et minimale B, est ainsi défini pour correspondre à la première gamme de longueurs d'onde tandis que le dimensionnement des trous traversants 231 de la deuxième portion 22 est défini pour correspondre à la deuxième gamme de longueurs d'onde. De cette manière, ce sont majoritairement les parties du rayonnement électromagnétique se trouvant respectivement dans la première et la deuxième gamme de longueur d'onde qui sont transmises respectivement à la première et à la deuxième structure 111, 112.

Si le composant 1 selon ce deuxième mode de réalisation peut être fabriqué de manière similaire au procédé de fabrication décrit pour le premier mode de réalisation, il peut également être fabriqué en variante selon le procédé suivant.

Ce procédé de fabrication comporte les étapes suivantes de :

- fourniture du support 10 comportant la première et la deuxième structure 111, 112 et la face de réception 121 pour recevoir le rayonnement électromagnétique,
- formation de la couche d'adaptation 220 recouvrant au moins en partie la face de réception 121 du support 10 et présentant un indice de réfraction dans la première gamme de longueurs d'onde qui est inférieur à 1,5,
- formation de la couche métallique 230 recouvrant la couche d'adaptation 220 et comprenant des trous traversants 231 régulièrement répartis et dimensionnés pour former une surface sélective en fréquence, chacun des trous traversants 231 contenant un matériau de remplissage 232 dont l'indice de réfraction dans la première gamme de longueurs d'onde est supérieur à 2.

Cette dernière étape de formation de la couche métallique 230 peut, de manière similaire au procédé de fabrication d'un composant selon le premier mode de réalisation, comporter pour former la couche métallique 230 une étape de dépôt de métal selon le procédé damascène.

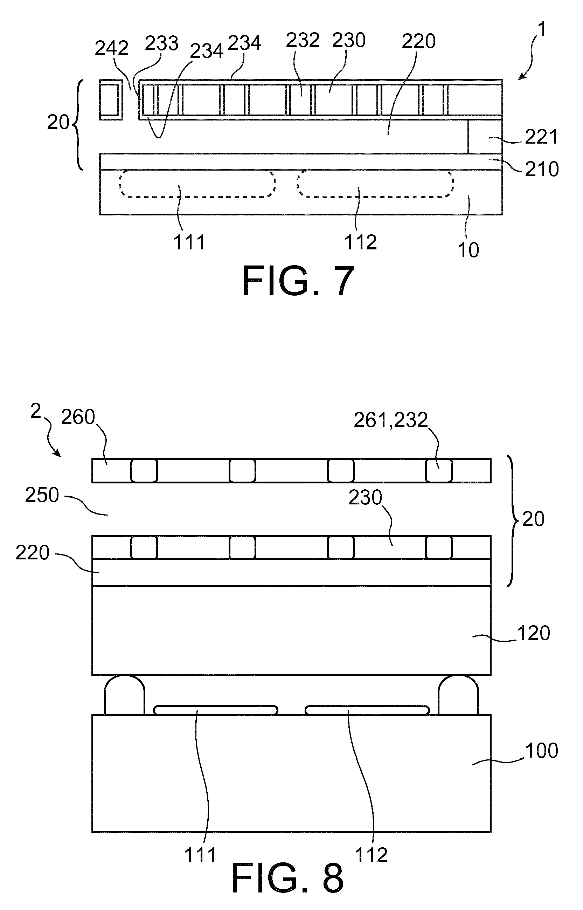

La figure 7 illustre un composant selon un troisième mode de réalisation de l'invention dans lequel la zone d'adaptation 220 est formée par un deuxième espace creux aménagé entre le support et la première couche métallique 230. Un tel deuxième espace creux présente, en effet, de par le gaz qu'il contient, ou la faible pression y régnant, un indice de réfraction dans la première gamme de longueur d'onde qui est proche de 1, voire égal à 1. Un tel indice proche de 1 est ainsi particulièrement avantageux dans le cadre de l'invention, puisqu'elle permet d'optimiser le taux de réjection du filtre optique 20 que le composant comporte.

Un tel composant se différencie d'un composant selon le premier mode de réalisation de l'invention en ce que le support 10 est constitué d'un unique substrat dans lequel une première et deuxième structure 111, 112 sont aménagées, en ce que le filtre optique 20 est configuré pour permettre de filtrer deux gammes de longueurs d'onde, et en ce que la zone d'adaptation est creuse à l'exception d'un élément formant pilier 221 permettant d'assurer l'espacement entre la couche de collage 210 et la première couche métallique 230.

Selon ce troisième mode de réalisation, le support 10 comporte une première et une deuxième face, la première face formant face de réception 121 pour recevoir le rayonnement électromagnétique.

La première et la deuxième structure 111, 112 sont, comme dans le deuxième mode de réalisation, toutes deux des structures du type photodiode et seul leur emplacement est figuré en pointillé sur la figure 7. La surface active de chacune des structures 111, 112 se trouve à la surface de la face de réception 121 du support 10.

Contrairement au composant 1 selon le premier mode de réalisation, le placement du filtre optique 20 sur la face de réception du support se fait au moyen d'une couche de collage 210, la couche de collage 210 faisant alors interface entre la zone d'adaptation 220 et la face de réception 121.

Le procédé de fabrication d'un composant selon ce troisième mode de réalisation se différencie du procédé décrit en relation des figures 3A à 3H en ce que :

- lors du dépôt du métal pour former la première couche métallique, il est aménagé dans cette dernière une percée 242 afin d'autoriser la suppression d'une couche sacrificielle, non illustrée, disposée à l'emplacement de la zone d'adaptation 220,
- il n'est pas prévu d'étape de fixation de la zone d'adaptation sur le support 10
- l'étape de dépôt de la zone d'adaptation comprend les sous-étapes suivantes :

  • dépôt d'une première couche sacrificielle en contact avec la deuxième couche de matériau d'interface, une ouverture étant prévue pour la formation du pilier 221,
  • formation du pilier 221 au travers de l'ouverture prévue,
  • fixation de la première couche sacrificielle par sa face opposée à la première couche métallique 230 sur le support 10 au moyen d'une couche de collage 210, le pilier 221 étant également fixé au support au moyen de la couche de collage 210,
  • gravure de la première couche sacrificielle au travers de la percée 242.

La figure 8 illustre un composant 2 selon un quatrième mode de réalisation de l'invention. Un tel composant 2 se différencie d'un composant 1 selon le premier mode de réalisation en qu'il est prévu une deuxième couche métallique 260 formant surface sélective en fréquence et en ce que la première et la deuxième couche métallique 230, 260 sont séparées l'une de l'autre par un premier espace creux 250. Un tel composant 1 permet, en plus des avantages déjà présentés pour un composant selon le premier mode de réalisation de l'invention, d'obtenir un taux de réjection optimisé de par la présence de la deuxième couche métallique 260 sans que le taux de transmission dans la première gamme de longueurs d'onde ne soit significativement affecté.

La deuxième couche métallique 260 présente une configuration sensiblement identique à celle de la première couche métallique 230. Ainsi la deuxième couche métallique 260 comporte des deuxièmes trous traversants 261 selon une configuration sensiblement identique aux premiers trous traversants 231 de la première couche métallique 260, ces deuxièmes trous traversants 261 contenant également du matériau de remplissage 232 et le matériau d'interface 234, non représenté et qui est présent dans un espacement 233 entre la deuxième couche métallique 260 et le matériau de remplissage 234.

La première et la deuxième couche métallique 230, 260, s'étendent parallèlement l'une à l'autre espacé par le premier espace creux 250 d'une distance d. La distance d respecte les inégalités suivantes :

$$(1) \qquad \frac{\lambda}{6} \le d \le \frac{\lambda}{3},$$

λ étant la longueur d'onde autour de laquelle est centrée la première gamme de longueur d'onde. Idéalement, et notamment lorsque le filtre ne comporte pas de deuxième portion pour filtrer dans une deuxième gamme de longueur d'onde, d est choisi comme sensiblement égal à λ/4.

On peut noter que selon une possibilité de l'invention non illustré, il est également possible d'optimiser la zone d'espacement inter-couche métallique même si cette dernière n'est pas fournie par un premier espace creux 250 selon l'invention. Une telle optimisation peut être obtenue en fournissant une zone d'espacement inter-couche métallique réalisée dans un matériau présentant un indice de réfraction dans la première gamme de longueurs d'onde inférieur à 2, préférentiellement à 1,7, voire 1,5 et en dimensionnant cette zone inter-couche métallique de manière à ce qu'elle sépare la première et la deuxième couche métallique 230, 260 d'une distance d respectant l'équation suivante :

$$(2) \qquad \frac{\lambda}{6n} \leq d \leq \frac{\lambda}{3n},$$

λ étant la longueur d'onde autour de laquelle est centrée la première gamme de longueur d'onde et n l'indice de réfraction de la zone d'espacement inter-couche métallique. Idéalement, et notamment lorsque le filtre ne comporte pas de deuxième portion pour filtrer dans une deuxième gamme de longueur d'onde, d est choisi comme sensiblement égal à λ/4n.

Ainsi, le filtre optique 20 selon l'invention comporte :

- une couche de collage 210,
- une zone d'adaptation 220 recouvrant au moins en partie la face de réception du support 20, la zone d'adaptation 220 étant fixée à la face de réception 121 au moyen de la couche de collage 210,
- une première couche métallique 230 recouvrant la zone d'adaptation 220 et comprenant des premiers trous traversants 231 régulièrement répartis et dimensionnés pour que la première couche métallique 230 forme une surface sélective en fréquence,
- un premier espace creux 250,
- une deuxième couche métallique 250 recouvrant la zone d'adaptation 220 et comprenant des deuxièmes trous traversants 261 régulièrement répartis et dimensionnés selon une configuration sensiblement identique aux premiers trous traversants 231 de la première couche métallique 230, le premier espace creux 250 séparant de la distance d la première et la deuxième couche métallique 230, 260.

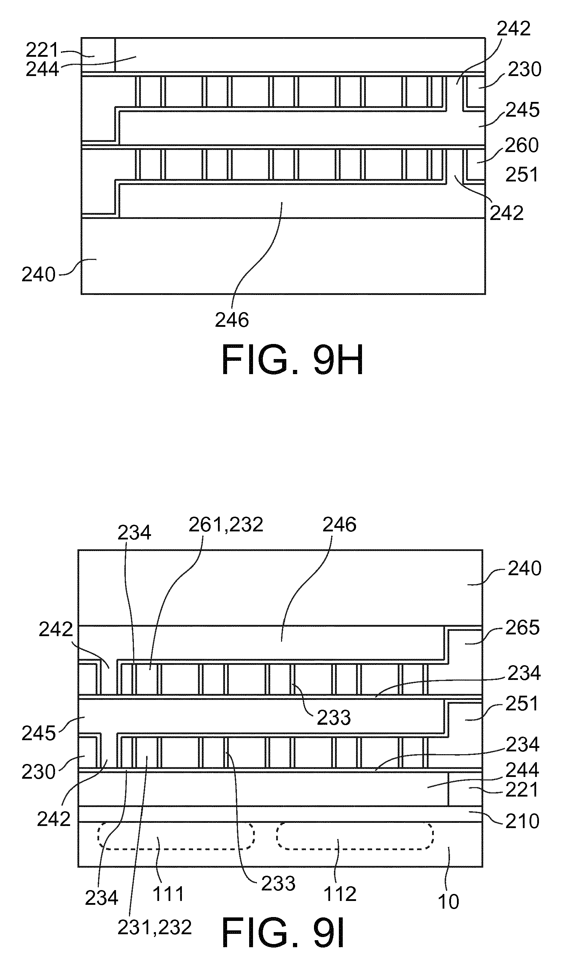

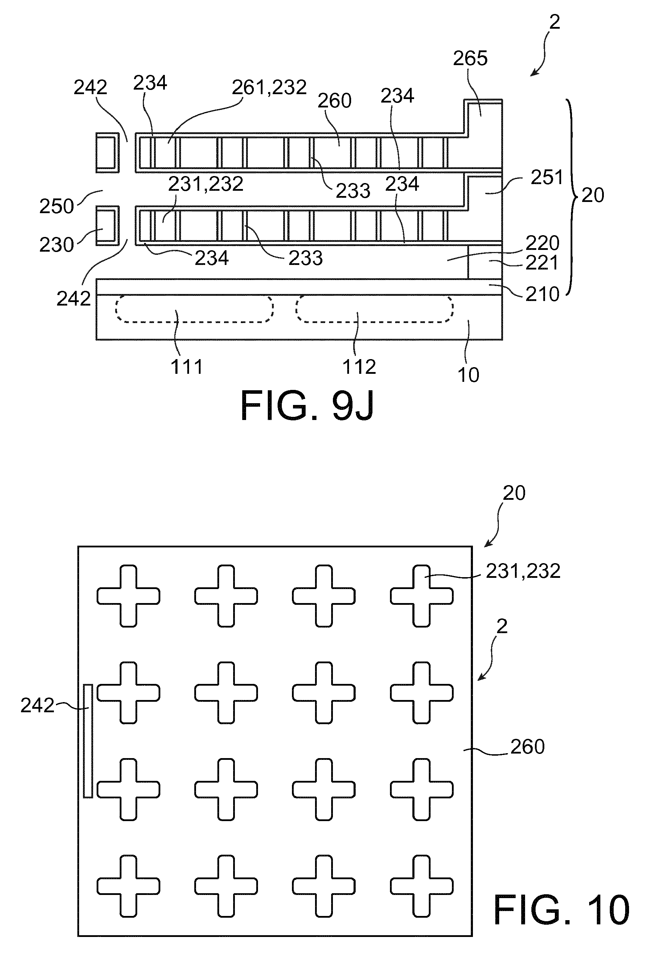

On notera que la figure 8 permet d'illustré le principe d'un composant selon l'invention et que cette dernière ne représente pas les éléments de support, tels que des piliers ou encore un cadre extérieur, qui permettent d'assurer le maintien de la deuxième couche métallique 260 espacée de la première couche métallique 230 et donc de former le premier espace creux 250. Bien entendu de tels éléments sont généralement présents comme le montre la figure 9J qui illustre la présence d'un tel pilier 210.

Ainsi la figure 9J illustre un composant 2 selon un cinquième mode de réalisation de l'invention dans lequel la zone d'adaptation 220 est formée par un deuxième espace creux, et non par une couche comme c'est le cas pour le composant selon la figure 8, et dans lequel, de manière identique au composant illustré sur la figure 7, le support 10 comporte la première et la deuxième structure 111, 112.

Dans un tel composant 2, la première et la deuxième couche métallique 230 et 260 comportent toutes deux une percée 242 afin d'autoriser la suppression de couches sacrificielles 244, 245, telles qu'illustrées sur la figure 9I, et permettre la formation du premier espace creux 250 et la zone d'adaptation 220. La zone d'adaptation 220, c'est-à-dire le deuxième espace creux, et le premier espace creux 250 comprennent respectivement un premier et un deuxième pilier 221, 251 formant chacun élément de support. Ainsi, le premier pilier 221 permet de maintenir à distance la première couche métallique 230 du substrat 10, tandis que le deuxième pilier 251 permet de maintenir à distance la deuxième couche métallique 260 de la première couche métallique 230.

Bien entendu, si chacune de la zone d'adaptation 220 et de la premier espace creux 250 présente sur la figure 9J un unique pilier 221, 251 respectif pour une surface correspondant à deux structures 111, 112, d'autres configurations sont également envisageables sans que l'on sorte du cadre de l'invention. Ainsi par exemple, il pourrait également envisageable de prévoir un nombre de piliers différent pour la zone d'adaptation 220 et le premier espace creux250 ou encore prévoir pour chacun un pilier pour une surface correspondant une structure 111, 112.

On notera également que dans ce cinquième mode de réalisation, le composant comporte un troisième pilier 265 faisant saillie de la deuxième couche métallique 260. Un tel troisième pilier 265, comme cela est décrit ci-dessous, a pour origine le procédé de fabrication utilisé pour fabriquer le composant 2 selon ce cinquième mode de réalisation. Un tel troisième pilier 265, après fabrication du composant 2, ne possédant aucune fonction particulière et il peut donc être prévu une étape de suppression d'un tel troisième pilier 265.

Bien entendu, selon un principe similaire au procédé de fabrication d'un composant 1 selon lᵉ troisième mode de réalisation, il est également envisageable de prévoir un procédé de fabrication dans lequel un tel troisième pilier 265 n'est pas nécessaire.

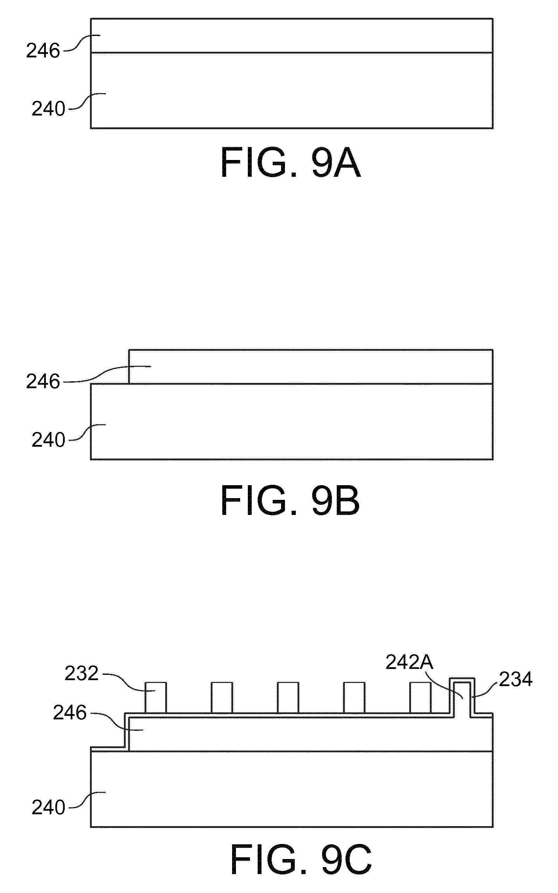

Les figures 9A à 9J illustrent les principales étapes de fabrication du composant illustré sur la figure 9J. Un tel procédé de fabrication comporte les étapes suivantes :

- fourniture d'un substrat sacrificiel 240,

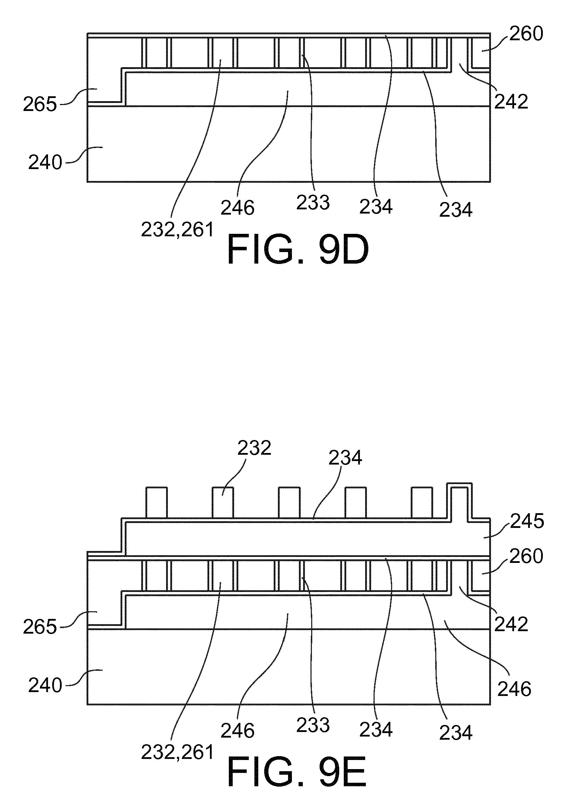

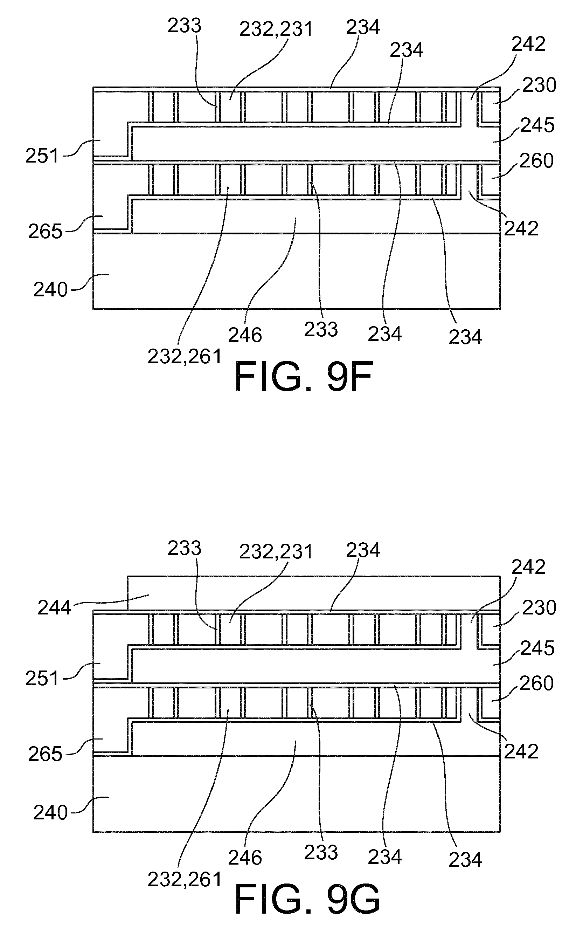

- dépôt d'une première couche sacrificielle 246, tel qu'illustré sur la figure 9A,
- aménagement dans la première couche sacrificielle 246 d'une ouverture pour la formation du troisième pilier 221, tel qu'illustré sur la figure 9B,
- formation d'un premier plot sacrificiel pour fournir la percée 242 de la deuxième couche métallique 260,
- dépôt d'une couche du matériau d'interface 234 en contact avec la première couche sacrificielle 246, du plot sacrificiel, et du substrat sacrificiel 240 par l'ouverture pour la formation du troisième pilier 271,
- dépôt du matériau de remplissage 232 selon une conformation correspondant aux deuxièmes trous traversants de la deuxième couche métallique 260 selon une méthode similaire à celle illustrée sur les figures 3B à 3C,
- dépôt sélectif de matériau d'interface 234 sur le matériau de remplissage 232 de manière à encapsuler le matériau de remplissage 232, comme cela est illustré sur la figure 9C,
- dépôt d'un métal, tel que du cuivre en contact avec la surface de la première couche d'interface dans les espaces laissés libre par le matériau de remplissage 232 pour former la deuxième couche métallique 230 et le troisième pilier 265,
- dépôt d'une couche de matériau d'interface 134 en contact avec la deuxième couche métallique et du matériau de remplissage affleurant de la deuxième couche métallique, tel qu'illustré sur la figure 9D,
- dépôt d'une deuxième couche sacrificielle 245,
- aménagement dans la deuxième couche sacrificielle 245 d'une ouverture pour la formation du deuxième pilier 251,
- formation d'un deuxième plot sacrificiel pour fournir la percée 242 de la première couche métallique 230,
- dépôt d'une couche du matériau d'interface 234 en contact avec la deuxième couche sacrificielle 245,
- dépôt du matériau de remplissage 232 selon une conformation correspondant aux premiers trous traversants de la première couche métallique 230 selon une méthode similaire à celle illustrée sur les figures 3B à 3C, tel qu'illustré sur la figure 9E,
- dépôt sélectif de matériau d'interface 234 sur le matériau de remplissage 232 de manière à encapsuler le matériau de remplissage 232,
- dépôt du même métal que celui utilisé pour la formation de la deuxième couche métallique 260 en contact avec la surface de la deuxième couche d'interface dans les espaces laissés libre par le matériau de remplissage 232 pour former la première couche métallique 230 et le deuxième pilier 251,
- dépôt d'une couche de matériau d'interface 134 en contact avec la deuxième couche métallique et du matériau de remplissage affleurant de la deuxième couche métallique, tel qu'illustré sur la figure 9F,
- dépôt d'une troisième couche sacrificielle 247
- aménagement dans la troisième couche sacrificielle 247 d'une ouverture pour la formation du premier pilier 221, tel qu'illustré sur la figure 9G,
- dépôt du même métal que celui utilisé pour la formation de la deuxième et de la première couche métallique 260, 230 pour former le premier pilier 221,
- fourniture d'un support 10 dans lequel une première et deuxième structure 111, 112 sont aménagées,
- fixation de l'ensemble substrat sacrificiel/couches sacrificielles/ couches métalliques sur le support 10 par la troisième couche sacrificielle 24 et le premier pilier 221 et au moyen d'une couche de collage 210, tel qu'illustré sur la figure 9I,
- Suppression du substrat sacrificiel 240, des première, deuxième et troisième couche sacrificielle ceci en passant par les percées former en supprimant les plots sacrificiels ceci de manière à former l'espace creux correspondant à la zone d'adaptation 220 et le premier espace creux 250, tel qu'illustré sur la figure 9J.

La figure 10 illustre une vue de dessus d'un composant 2 obtenu lors de la mise en oeuvre d'un procédé de fabrication tel que décrit ci-dessus. On peut observer qu'un tel composant 2, outre la présence d'une deuxième couche métallique 260, se différencie en ce qu'il présente en plus des deuxièmes trous traversants la percée 242.

L'étape de dépôt du matériau de remplissage 232 selon une conformation correspondant aux trous traversants 231 de la première couche métallique 230 peut comporter les sous-étapes suivantes :

- dépôt d'une couche de matériau photosensible, non représenté, sur la couche du matériau d'interface 234 en contact avec la deuxième couche sacrificielle 245,
- insolation et révélation de la couche de matériau photosensible de manière à libérer des zones de la couche de matériau 234 en contact avec la deuxième couche sacrificielle, lesdites zones correspondant aux premiers trous traversants 231 de la première couche métallique 230,
- dépôt du matériau de remplissage 232 au travers de la couche photosensible en contact des zones libérées de la de la couche de matériau 234 en contact avec la deuxième couche sacrificielle,
- suppression de la couche de matériau photosensible.

En variante, l'étape de dépôt du matériau de remplissage 232 selon une conformation correspondant aux premiers trous traversants de la première couche métallique peut comporter également les sous-étapes suivantes :

- dépôt d'une couche du matériau de remplissage, non illustrée, en contact de la couche de matériau d'interface 234 en contact avec la deuxième couche sacrificielle,

- dépôt d'une couche de matériau photosensible en contact avec la couche de matériau de remplissage,
- insolation et révélation de la couche de matériau photosensible de manière à protéger uniquement les zones de la couche de matériau de remplissage correspondant aux premiers trous traversants de la première couche métallique 230,
- gravure des zones de la couche de matériau de remplissage non protégées,
- suppression de la couche de matériau photosensible.

Bien entendu de telles étapes de dépôt du matériau de remplissage 232 selon une conformation correspondant aux premiers trous traversant peut aisément être adaptée pour être appliquée à l'étape de dépôt du matériau de remplissage 232 selon une conformation correspondant aux deuxièmes trous traversants 261 de la deuxième couche métallique 260. Ceci est d'autant plus vrai que selon l'invention les premiers et les deuxièmes trous traversants 231, 261 présentent une conformation sensiblement identique.

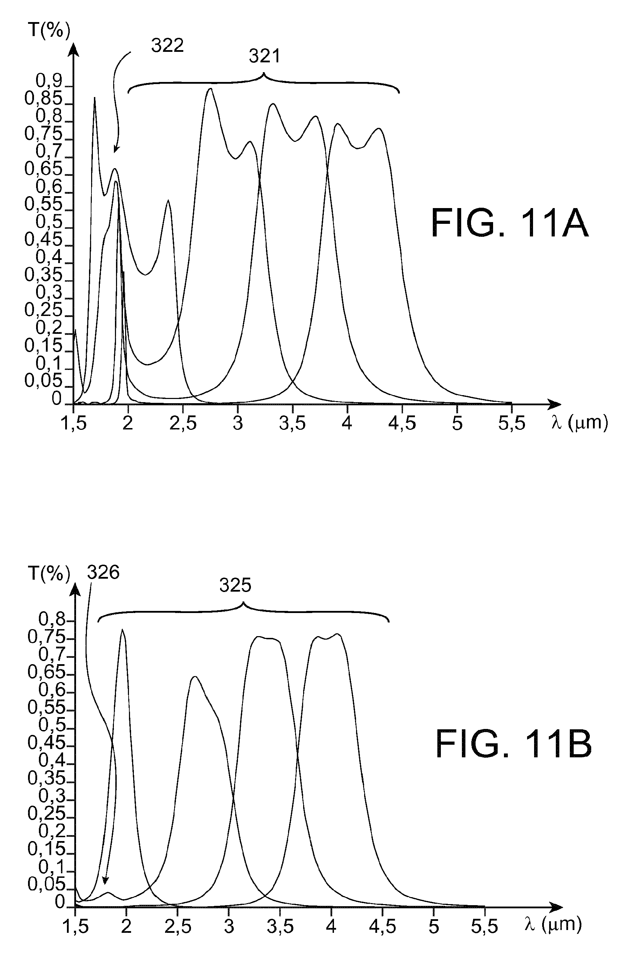

Les figures 11A et 11B illustrent respectivement la variation du taux de transmission 321 de composants s comportant une première et une deuxième couche métallique espacé par zone d'espacement inter-couche métallique en dioxyde de silicium, et la variation du taux de transmission d'un composant selon le troisième mode de réalisation de l'invention, ceci pour plusieurs configurations des premiers et deuxièmes trous traversants de manière à illustrer le bénéfice de l'invention pour plusieurs premières gamme de longueur d'onde comprise dans la gamme de l'infrarouge.

Ainsi, les variations de taux de transmission telles qu'illustrées sur la figure 11A ont été calculées pour des composants présentant une configuration similaire à celle d'un composant selon l'invention dont la zone d'adaptation 220 et le premier espace creux 250 ont été emplies d'un dioxyde de silicium.

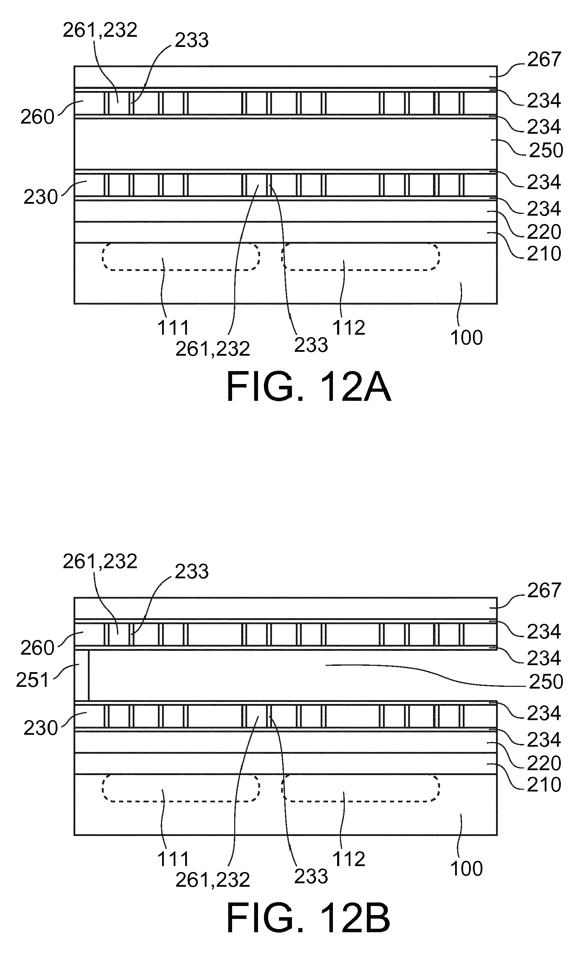

La configuration partagée par les composants selon l'invention et ceux dont les taux de transmission est illustrés sur la figure 11A est, en référence aux figures 12A et 12B, la suivante :

- chacun des composants comportent en partant de la face de réception en allant vers le milieu incident, c'est-à-dire le support :

  ○ une couche de passivation 267 en dioxyde de silicium et d'épaisseur 20 nm,
  ○ une couche d'interface 234 en nitrure de silicium faisant une épaisseur de 20 nm,
  ○ une deuxième couche métallique 260 en cuivre de 100 nm d'épaisseur,
  ○ une couche d'interface 234 en nitrure de silicium faisant une épaisseur de 20 nm,
  ○ un zone d'espacement inter-couche métallique, celle-ci étant en dioxyde de silicium pour les composants dont les taux de transmission sont illustrés sur la figure 11A et creuse, c'est dire emplie d'air, pour les composants selon l'invention,
  ○ une couche d'interface 234 en nitrure de silicium faisant une épaisseur de 20 nm,
  ○ une première couche métallique 239 en cuivre de 100 nm d'épaisseur,
  ○ une couche d'interface 234 en nitrure de silicium faisant une épaisseur de 20 nm,
  ○ une couche d'adaptation 220 en dioxyde de silicium de 200 nm d'épaisseur,
  ○ une couche de collage 210 de 300 nm dont l'indice optique n est égal à 1,6,
  ○ le support, celui-ci ayant été choisi avec un indice de réfraction n de 3,4.

- Le motif des trous traversants sont des anneaux tels qu'illustrés sur la figure 2B,
- les valeurs A des trous traversants des composants correspondant aux première, deuxième, troisième et quatrième courbes sont respectivement égales à 800 nm, 700 nm, 420 nm et 800 nm,
- les valeurs B des trous traversants des composants correspondant aux première, deuxième, troisième et quatrième courbes sont respectivement égales à 460 nm, 0 nm, 0 nm et 300 nm,
- le pas de réseau selon lequel les trous traversants sont répartis dans la première et la deuxième couche métallique est égal à la valeur A à laquelle il a été ajoutée 300 nm,
- chacun des trous traversants comporte du silicium en tant que matériau de remplissage et un espacement entre la couche métallique et le matériau de remplissage de 20 nm, ce dernier espacement 233 comportant du nitrure de silicium en tant que matériau d'interface 234.

En ce qui concerne la figure 10B, les structures selon l'invention comporte un premier espace creux 250 qui sépare la première et la deuxième couche métallique 230, 260 l'une de l'autre d'une distance d respectant

l'égalité $d = \dfrac{\lambda}{4}$.

On peut ainsi voir sur la figure 11A qu'avec une telle conformation, les composants comportant une zone d'espacement inter-couche métallique en dioxyde de silicium présentent sur toute la gamme des infrarouge un taux de rejection relativement important vis-vis d'un composant comportant une unique première couche métallique 230, à l'exception d'un pic de transmission 232 centré autour de 2 μm. Dans la première gamme de longueur d'onde par contre, le taux de transmission 231 dépasse pas, ou peu, les 80% et n'est pas constant sur toute la première gamme de longueur d'onde. On note ainsi une baisse relativement importante du taux de transmissions au centre de la gamme de longueur d'onde.

Pour un composant selon l'invention, on peut également noter que le taux de rejection est également important ceci sans exception, la variation du taux de transmission ne présentant pas de pic de transmission 236 en dehors de la première gamme de longueur d'onde. Qui plus est le taux de transmission 235 dans la première gamme dépasse les 80% pour la majorité des composants et présente une variation plus contenue vis-à-vis de celle observée pour les composants comportant zone d'espacement inter-couche métallique en dioxyde de silicium. Ainsi un composant selon l'invention présente un taux de transmission 235 dans la première gamme de longueur d'onde optimisé tout en conservant un taux de rejection important observé pour les composants comportant zone d'espacement inter-couche métallique en dioxyde de silicium et ceci sans exception, puisqu'aucun pic de transmission n'est observé en dehors de la première gamme de longueur d'onde.

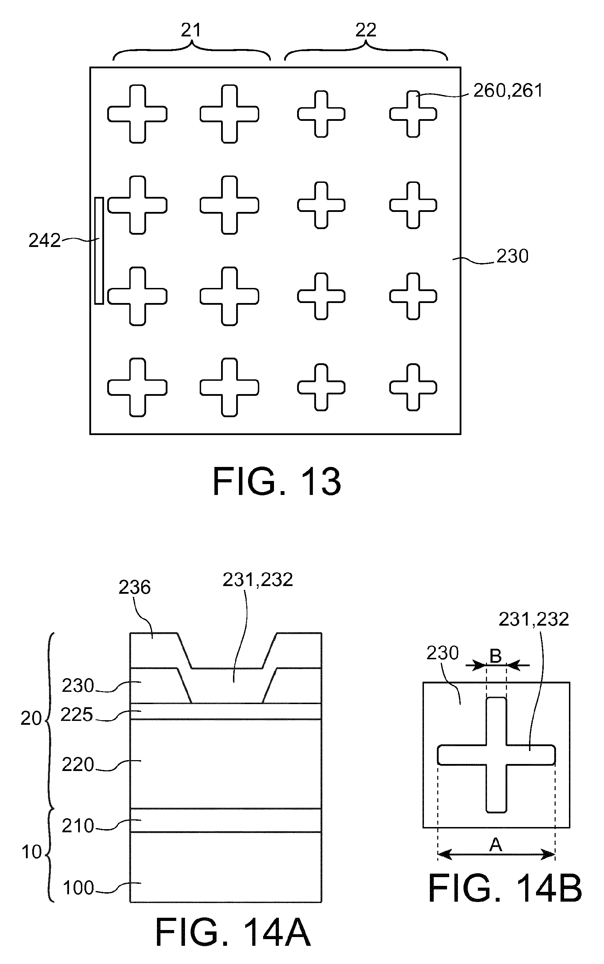

Selon une variante de l'invention applicable aux composants 2 selon le quatrième et le cinquième mode de réalisation et de manière similaire au composant selon le deuxième mode de réalisation, le filtre optique 20 peut présenter, comme illustré sur la figure 13, une première portion 21 dans laquelle le filtre est un filtre passe bande dans la première gamme de longueurs d'onde et une deuxième portion 22 dans laquelle le filtre est un filtre passe bande dans une deuxième gamme de longueurs d'onde. Un composant 1 selon cette variante se différencie d'un composant 1 selon le quatrième mode de réalisation et le cinquième mode de réalisation en ce que les premiers et deuxièmes trous traversants 231, 261 présentent sur la première portion 21 du filtre optique 20 un premier dimensionnement et sur une deuxième portion du filtre 22 un deuxième dimensionnement correspondant respectivement à la première et la deuxième gamme de longueurs d'onde.

Les premiers et deuxièmes trous traversants 230, 261 sont ménagés dans la première et la deuxième portion 21, 22 des première et deuxième couche métallique 230, 260 du filtre optique 20 selon un réseau carré avec un pas constant. Ainsi, la première et la deuxième portion 21, 22 du filtre optique 20 se distingue uniquement de par la forme des premiers et deuxièmes trous traversants 231, 261 qu'elles contiennent. Le dimensionnement des trous traversants 231 de la première portion 11, notamment leurs dimensions maximale A et minimale B, est ainsi défini pour correspondre à la première gamme de longueurs d'onde tandis que le dimensionnement des premiers et deuxièmes trous traversants 231 de la deuxième portion 22 est défini pour correspondre à la deuxième gamme de longueurs d'onde. De cette manière, ce sont majoritairement les parties du rayonnement électromagnétique se trouvant respectivement dans la première et la deuxième gamme de longueur d'onde qui sont transmises respectivement à la première et à la deuxième structure 111, 112.

On notera bien entendu que le premier espace creux 250 permet de séparer la première et la deuxième couche métallique 230, 260 de la distance d en respectant pour chacune de la première et de la deuxième gamme de longueur d'onde les inégalités (1).

La figure 14A illustre schématiquement un exemple de mise en oeuvre pratique d'un composant 2 selon le premier mode de réalisation dans lequel le composant 2 est destiné à la détection et/ou la mesure d'un rayonnement électromagnétique dans quatre gammes longueurs d'onde :

- une première gamme de longueurs d'onde comprise entre 2 et 2,5 $\mu$m,
- une deuxième gamme de longueurs d'onde comprise entre 3,2 et 3,5 $\mu$m,
- une troisième gamme de longueurs d'onde comprise entre 3,5 et 4,3 $\mu$m, et
- une quatrième gamme de longueurs d'onde comprise entre 4,5 et 4,8 $\mu$m.

La figure 14A illustre la configuration des premiers trous traversants de la couche métallique 230 d'un tel composant 2. Ainsi, comme illustré sur la figure 14A, un tel composant 2 comporte :

- un support 10 comportant la face de réception 121 pour recevoir le rayonnement électromagnétique et au moins une première, une deuxième, une troisième et une quatrième structure, non illustrées, chacune associée à une portion respective du support,
- un filtre optique 20 comportant, en association avec les structures, au moins une première, une deuxième, une troisième et une quatrième portion, non représentées, associées à respectivement la première, la deuxième, la troisième et la quatrième structure, le filtre optique étant disposé sur la face de réception 121 du support 10 de manière à filtrer le rayonnement électromagnétique transmis au support 10.

Le support 10 comporte un substrat 100 semiconducteur présentant au moins une couche de tellurure de mercure cadmium CdHgTe, non illustrée, dans laquelle sont réalisées les première, deuxième, troisième et quatrième structures. Ainsi les première, deuxième, troisième et quatrième structures sont des structures du type photodiode, telles que des photodiodes à avalanche, ou photodétecteur à barrière réalisées en tellurure de mercure cadmium CdHgTe. Les première, deuxième, troisième et quatrième structures présentent un agencement du type matriciel dans le substrat avec une distance entre deux structures adjacentes sensiblement égal à 15 $\mu$m.

Le support 10 comporte, comme illustrée sur la figure 14A, une couche de passivation 110 passivant la surface du substrat 100. Ainsi, la face de la couche de passivation 110 opposée au substrat forme la surface de réception 121 du support 10. La couche de passivation 110 comporte une épaisseur de 50 nm.Le filtre optique 20 est en contact avec la couche de passivation en étant disposé sur la surface de réception. Le filtre optique comporte :

- une couche d'adaptation 210 formant zone d'adaptation réalisée en dioxyde de silicium en contact avec la surface de réception 121 du support 10,
- une couche intermédiaire 225 en sulfure de zinc ZnS en contact avec la couche d'adaptation 210 sur une face de cette dernière qui est opposée à la surface de réception 121,
- une couche métallique 230 comportant une sous-couche d'accroche en titane Ti, non représentée, et une sous-couche principale en or Au, la couche métallique 230 comportant une première, une deuxième, une troisième et une quatrième portion associées respectivement aux première, deuxième, troisième et quatrième portion du filtre optique, chacune des première, deuxième, troisième et quatrième portion de la couche métallique 230 comportant des trous traversants 331 dimensionnés respectivement afin qu'elles forment une surface sélective en fréquence dans respectivement la première, la deuxième, la troisième et la quatrième gamme de longueurs d'onde, chacun des trous traversants contenant du sulfure de zinc en tant que matériau de remplissage, la couche métallique étant en contact avec la couche intermédiaire 225 sur une face de cette dernière qui est opposée à la couche d'adaptation 220,
- une couche superficielle 236 de sulfure de zinc ZnS recouvrant la surface métallique 230 sur une face de cette dernière qui est opposé à la couche intermédiaire 225.

Dans cette application pratique, le filtre peut être dimensionné comme suit :

- la couche d'adaptation 220 présente une épaisseur comprise entre 375 et 425 nm en étant préférentiellement sensiblement égale à 400 nm,
- la couche intermédiaire 225 de sulfure de zinc ZnS présente une épaisseur comprise entre 35 et 65 nm en étant préférentiellement sensiblement égale à 50 nm,
- la sous-couche d'accroche de titane présente une épaisseur comprise entre 5 et 20 nm en étant préférentiellement sensiblement égale à 20 nm,
- la sous-couche principale en or Au comporte présente une épaisseur comprise entre 80 et 145 nm en étant préférentiellement sensiblement égale à 130 nm,
- la couche superficielle 236 de sulfure de zinc ZnS présente une épaisseur comprise entre 35 et 65 nm en étant préférentiellement sensiblement égale à 50 nm.

Les premiers trous traversants 231 de la couche métallique 230 sont répartis dans la couche selon un réseau hexagonal bidimensionnel dont le pas est sensiblement égal à 400 nm. Les trous traversants 231 présente, comme illustré sur la figure 14B, une forme en croix. Le dimensionnement des premiers trous dans les première, deuxième, troisième et quatrième portions de la couche métallique peut être le suivant :

- dans la première portion, A et B sont respectivement égales à 500 nm et 0,
- dans la deuxième portion, A et B sont respectivement égales à 1000 nm et 300 nm,
- dans la troisième portion, A et B sont respectivement égales à 1100 nm et 400 nm,
- dans la quatrième portion, A et B sont respectivement égales à 1200 nm et 600 nm.

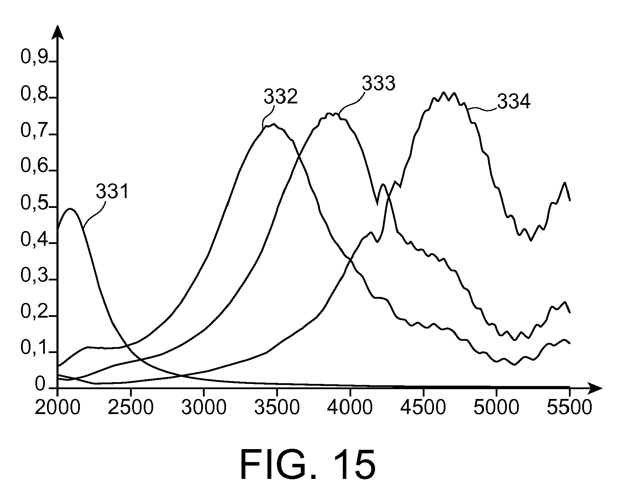

De cette manière et comme le montre la figure 15 qui présente les spectres 331, 332, 333, 334 de transmission calculés pour les première, deuxième, troisième et quatrième portions du filtre optique 20 d'un composant 2 selon cette exemple pratique. On peut ainsi voir que :

- la première portion du filtre optique 20 permet d'obtenir une transmission de sensiblement 50% dans la première gamme de longueurs d'onde, comme le montre le spectre en transmission 331,
- la deuxième portion du filtre optique 20 permet d'obtenir une transmission de sensiblement 70% dans la deuxième gamme de longueurs d'onde, comme le montre le spectre en transmission 332,
- la troisième portion du filtre optique 20 permet d'obtenir une transmission de sensiblement 75% dans la troisième gamme de longueurs d'onde, comme le montre le spectre en transmission 333,
- la quatrième portion du filtre optique 20 permet d'obtenir une transmission de sensiblement 80% dans la quatrième gamme de longueurs d'onde, comme le montre le spectre en transmission 334.

Il est donc possible, avec un composant selon l'invention, d'obtenir la détection de rayonnement électromagnétique dans quatre gammes de longueurs d'onde de l'infrarouge ceci uniquement en adaptant le dimensionnement des premiers trous traversants dans chacune des première, deuxième, troisième et quatrième portions du filtre optique 20.

On peut noter qu'en variante de cet exemple de mise en oeuvre, dans le cas où le composant est destiné à la détection de rayonnement dans la troisième et quatrième gamme de longueur d'onde, le matériau de remplissage 232 et la couche superficielle 236 peuvent être réalisé en germanium. Ainsi, dans ce cas le support 10, le filtre optique 20 et la couche métallique comporte uniquement les troisième et quatrième portions selon cet exemple de mise en oeuvre. Le dimensionnement des trous traversant desdites troisième et quatrième portion étant adapté au changement de matériau de remplissage 232.

Si dans les modes de réalisation et l'exemple de mise en oeuvre décrits ci-dessus chacun des composants 1 comporte au moins une première et une deuxième structure, la portée de l'invention ne se limite pas aux seuls composants comportant deux structures. Ainsi, l'invention couvre ainsi aussi bien les composants monostructure que les composants comportant un nombre plus important de structures. Un composant selon l'invention peut donc également avoir une centaine, voire plusieurs milliers ou encore plusieurs millions de structures sans que l'on sorte du cadre de l'invention. L'invention s'applique donc parfaitement aux capteurs du type photographique ou vidéo qui comportent des structures organisées sous forme de matrice.

On peut également noter que conformément au cinquième mode de réalisation, chacune des structures peut être associée à une portion du filtre optique et donc à une gamme de longueurs d'onde qui lui est propre. De cette manière il est possible avec un seul composant de détecter et/ou mesurer les différentes parties d'un rayonnement électromagnétique dans des gammes de longueurs d'onde parfaitement définies. Cette possibilité est particulièrement avantageuse puisqu'elle permet des applications à la spectroscopie et d'imagerie à plusieurs gammes de longueurs d'onde.

On peut également noter que si l'invention vise plus particulièrement les composants comportant des structures du groupe comprenant les bolomètres, les photodiodes et les photodétecteurs à barrière, un composant 1 selon l'invention peut également comporter une structure d'un autre type qui est apte à absorber un rayonnement électromagnétique sans que l'on sorte du cadre de l'invention.

De même, si dans le premier mode de réalisation, le capot 120 permet d'encapsuler ensemble les surfaces actives de la première et la deuxième structure, un composant selon l'invention peut également comporter, sans que l'on sorte du cadre de l'invention, un à plusieurs capots encapsulant de manière individuelle chacune des structures.

**Revendications**

1.  Composant (2) destiné à la détection et/ou la mesure d'un rayonnement électromagnétique dans une première gamme de longueurs d'onde comprise dans la gamme des infrarouges et du visible, ladite première gamme de longueurs d'onde étant centrée autour d'une longueur d'onde λ, le composant (1) comportant :

    - un support (10) comportant une face de réception (121) pour recevoir le rayonnement électromagnétique et au moins une première structure (111, 112) apte à absorber un rayonnement électromagnétique,
    - un filtre optique (20) dont au moins une première portion (21) associée à la première structure (111, 112) est du type filtre passe bande dans la première gamme de longueurs d'onde, le filtre optique (20) étant disposé sur la face de réception (121) du support (10) de manière à filtrer le rayonnement électromagnétique transmis au support (10),

    le filtre optique (20) comportant:

    - une zone d'adaptation (220) recouvrant au moins en partie la face de réception (121) du support (10), la zone d'adaptation (220) présentant un indice de réfraction dans la première gamme de longueurs d'onde qui est inférieur à 2,
    - une première couche métallique (230) recouvrant la zone d'adaptation (220) et comprenant des premiers trous traversants (231) répartis et dimensionnés pour que la couche métallique (230) forme une surface sélective en fréquence,

    le composant (2) **étant caractérisé en ce que** chacun des premiers trous traversants (231) contient un matériau de remplissage (232) dont l'indice de réfraction dans la première gamme de longueurs d'onde est supérieur à 2,

2.  Composant (2) selon la revendication 1, dans lequel les premiers trous (231) sont régulièrement répartis dans la première couche métallique.

3.  Composant (2) selon la revendication 1 ou 2, dans lequel dans chacun des premiers trous traversants (231) il est prévu un espacement (233) entre la couche métallique (230) et le matériau de remplissage (232), ledit espacement (233) étant configuré pour présenter un indice de réfraction dans la première gamme de longueurs d'onde inférieur à 2, préférentiellement à 1,7, voire 1,5, ceci soit en contenant un matériau d'interface (234) présentant ledit indice de réfraction, soit en étant vide de matériau.

4.  Composant (2) selon la revendication 3, dans lequel l'espacement est configuré pour présenter un indice de réfraction dans la première gamme de longueur d'ondes inférieur à 2, préférentiellement à 1,7, voire 1,5 en contenant un matériau d'interface (234), et dans lequel du matériau d'interface (234) est également positionné entre le matériau de remplissage (232) et la zone d'adaptation (220).

5.  Composant (2) selon la revendication 3 ou 4, dans lequel l'espacement est configuré pour présenter un indice de réfraction dans la première gamme de longueur d'ondes inférieur à 2, préférentiellement à 1,7, voire 1,5 en contenant un matériau d'interface (234), et dans lequel le matériau d'interface (234) est sélectionné dans le groupe comportant les dioxydes de silicium et les nitrures de silicium.

6.  Composant (2) selon l'une quelconque des revendications 1 à 5, dans lequel la zone d'adaptation est formée par un deuxième espace creux.

7.  Composant (2) selon l'une quelconque des revendications 1 à 6, le filtre optique (20) comprend en outre :

    - une deuxième couche métallique (260), ladite deuxième couche métallique (260) comprenant des deuxièmes trous traversants (261) selon une configuration sensiblement identique aux premiers trous traversants (231) de la première couche métallique (230), ces deuxièmes trous traversants (261) contenant également du matériau de remplissage (232),

    la première et la deuxième couche métallique (230, 260) étant séparées l'une de l'autre d'une distance d par un premier espace creux, la distance d respectant les inégalités suivantes :

    $$\frac{\lambda}{6} \geq d \geq \frac{\lambda}{3}.$$

8.  Composant (2) selon la revendication 7, dans lequel la distance d séparant l'une de l'autre la première et la deuxième couche métallique (230, 260) est sensiblement égale à $\frac{\lambda}{4}$.

9.  Composant (2) selon l'une quelconques des revendications 1 à 8, dans lequel le matériau de remplissage (232) est un matériau sélectionné dans le groupe comportant les siliciums, les germaniums, les sulfures de zinc et les tellurures de plomb.

10. Composant (2) selon l'une quelconque des revendications 1 à 9 qui est adapté pour en outre détecter un rayonnement électromagnétique dans une deuxième gamme de longueurs d'onde comprise dans la gamme des infrarouges et du visible, le composant (2) comportant en outre au moins une deuxième structure (112) destinée à la détection de rayonnements électromagnétiques,
    le filtre optique (20) comportant au moins une deuxième portion (22) associée à la deuxième structure (112) et qui est du type filtre passe bande dans la deuxième gamme de longueurs d'onde.

11. Procédé de fabrication d'un composant (2) destiné à la détection d'un rayonnement électromagnétique dans une première gamme de longueurs d'onde comprise dans la gamme des infrarouges et du visible, ladite première gamme de longueurs d'onde étant centrée autour d'une longueur d'onde λ, le procédé comportant les étapes suivantes :

    - fourniture d'un support (10) comportant au moins une première structure (111, 112) destinée à la détection de rayonnement électromagnétiques et une face de réception (121) pour recevoir le rayonnement électromagnétique,
    - formation d'une zone d'adaptation (220) recouvrant au moins en partie la face de réception (121) du support (10) et présentant un indice de réfraction dans la première gamme de longueurs d'onde qui est inférieur à 2,
    - formation d'une première couche métallique (230) recouvrant la zone d'adaptation (220) et comprenant des premiers trous traversants (231) répartis et dimensionnés pour former une surface sélective en fréquence, chacun des trous traversants (231) contenant un matériau de remplissage (232) dont l'indice de réfraction dans la première gamme de longueurs d'onde est supérieur à 2

12. Procédé de fabrication d'un composant (2) destiné à la détection d'un rayonnement électromagnétique dans une première gamme de longueurs d'onde comprise dans la gamme des infrarouges et du visible, ladite première gamme de longueurs d'onde étant centrée autour d'une longueur d'onde λ, le procédé comportant les étapes suivantes :

    - formation d'une première couche métallique (230), la première couche métallique comprenant des premiers trous traversants (231) répartis et dimensionnés pour former une surface sélective en fréquence, chacun des trous traversants (231) contenant un matériau de remplissage (232) dont l'indice de réfraction dans la première gamme de longueurs d'onde est supérieur à 2,
    - formation d'une zone d'adaptation (220) sur la première couche métallique (230) de manière à ce que la zone d'adaptation (220) soit couverte par la première couche métallique (230), la zone d'adaptation (220) présentant un indice de réfraction dans la première gamme de longueurs d'onde qui est inférieur à 2,
    - fourniture d'un support (10) comportant au moins une première structure (111, 112) apte à absorber un rayonnement électromagnétique et une face de réception (121) pour recevoir le rayonnement électromagnétique ou d'une partie (120) de support (10) destinée à la formation d'un tel support (10) et comportant la face de réception (121) dudit support (10),
    - report de l'ensemble zone d'adaptation (220), première couche métallique (230) et substrat sacrificiel (240) sur la face de réception (121) de manière à ce que la zone d'adaptation (220) recouvre au moins en partie la face de réception (121),

- suppression au moins en partie le substrat sacrificiel (240).

**13.** Procédé de fabrication selon la revendication 11 ou 12, dans lequel lors de l'étape de formation de la couche première couche métallique (230) les premiers trous (231) sont régulièrement répartis dans la première couche métallique (230).

**14.** Procédé de fabrication selon l'une quelconque des revendications 11 à 13, dans lequel au moins l'une des étapes de formation de la première couche métallique (230) et de l'étape de formation de la deuxième couche métallique (260) comporte les sous-étapes suivantes :

- dépôt du matériau de remplissage (232) de manière à délimiter avec le matériau de remplissage au moins partiellement les trous traversants (231) de la première ou deuxième couche métallique (230, 260),
- dépôt d'une couche de matériau métallique de manière à remplir les espaces laissés libres par le matériau de remplissage (232) pour ainsi former la première couche métallique (230).

**15.** Procédé de fabrication selon la revendication 14, dans lequel lors de l'étape de dépôt du matériau de remplissage, le dépôt est réalisé de manière à ce que le matériau de remplissage (232) soit entouré de matériau d'interface (234) ceci pour définir lors du dépôt de matériau métallique un espacement (233) entre la première couche de métallique (230) et le matériau de remplissage (232).

FIG. 1A

FIG. 1B

FIG. 2A

FIG. 2B

FIG. 2C

FIG. 3A

FIG. 3B

FIG. 3C

FIG. 3D

234
233
231,232
230
234
235
240

## FIG. 3E

220
234
233
231,232
230
234
235
240

## FIG. 3F

120
210
220
234
233
231,232
230
234
235
240

## FIG. 3G

120
210
220
234
233
231,232
230
234
235

240

## FIG. 3H

FIG. 4A

FIG. 4B

FIG. 5

FIG. 6A

FIG. 6B

FIG. 7

FIG. 8

246

240

# FIG. 9A

246

240

# FIG. 9B

232    242A    234

246

240

# FIG. 9C

FIG. 9D

FIG. 9E

233    232,231    234    234    242

251    230    245    260

265    242

240    232,261    246    233    234    234

## FIG. 9F

244    233    232,231    234    242    230    245    260

251    242

265

240    232,261    246    233    234    234

## FIG. 9G

221
244
242
230
245
260
251
242

240

246

# FIG. 9H

234
261,232
246
240

242
265
234
251
234
244
221
210

245
230
242

233
233
234
231,232
111
112
10

# FIG. 9I

FIG. 9J

FIG. 10

FIG. 11A

FIG. 11B

261,232    233                                    267
                                                   234
260                                                234
                                                   250
230                                                234
                                                   234
                                                   220
                                                   210

111        112              100
261,232    233

# FIG. 12A

261,232    233                                    267
                                                   234
260                                                234
251                                                250
230                                                234
                                                   234
                                                   220
                                                   210

111        112              100
261,232    233

# FIG. 12B

21    22

260,261

242

230

## FIG. 13

236    231,232

230

225

220

210

100

20 {

10 {

## FIG. 14A

231,232

230    B

A

## FIG. 14B

FIG. 15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **KRISTENSEN.** *Journal of Applied Physics,* 2004, vol. 95, 4845